# EUROPÄISCHE PATENTSCHRIFT

(11) **EP 1 846 319 B1**
(45) Veröffentlichungstag und Bekanntmachung des Hinweises auf die Patenterteilung: **04.05.2016**
(21) Anmeldenummer: 06707838.6
(22) Anmeldetag: 25.01.2006
(51) Int. Cl.: B81C 1/00, G01L 9/00, H04R 19/00, H04R 19/04, H04R 31/00

(54) **MIKROMECHANISCHES BAUELEMENT UND ENTSPRECHENDES HERSTELLUNGSVERFAHREN**
MICROMECHANICAL COMPONENT AND CORRESPONDING PRODUCTION METHOD
COMPOSANT MICROMECANIQUE ET PROCEDE DE PRODUCTION CORRESPONDANT

(30) Priorität: 03.02.2005 DE 102005004877
(43) Veröffentlichungstag der Anmeldung: 24.10.2007
(73) Patentinhaber: ROBERT BOSCH GMBH, 70442 Stuttgart (DE)
(72) Erfinder: REICHENBACH, Frank, 72827 Wannweil (DE); LÄRMER, Franz, 71263 Weil Der Stadt (DE); KRONMÜLLER, Silvia, 71409 Schwaikheim (DE); SCHELLING, Christoph, 72762 Reutlingen (DE); FUCHS, Tino, 72072 Tübingen (DE); LEINENBACH, Christina, 66806 Ensdorf (DE)
(86) Internationale Anmeldenummer: PCT/EP2006/050439
(87) Internationale Veröffentlichungsnummer: WO 2006/082155

(56) Entgegenhaltungen:
- EP-A- 0 969 694
- US-A- 6 140 689
- US-A1- 2004 259 286
- US-B1- 6 667 189
- US-B1- 6 816 301
- US-B2- 6 790 699
- SCHEEPER P R ET AL: "A REVIEW OF SILICON MICROPHONES" SENSORS AND ACTUATORS A, ELSEVIER SEQUOIA S.A., LAUSANNE, CH, Bd. A44, Nr. 1, 1. Juli 1994 (1994-07-01), Seiten 1-11, XP000469147 ISSN: 0924-4247

## Beschreibung

### STAND DER TECHNIK

Die vorliegende Erfindung betrifft ein mikromechanisches Bauelement. Die vorliegende Erfindung betrifft ebenfalls ein entsprechendes Herstellungsverfahren.

Obwohl prinzipiell auch auf zahlreiche andere mikromechanische Bauelemente anwendbar, werden die vorliegende Erfindung sowie die ihr zugrundeliegende Problematik anhand von kapazitiven Siliziummikrofonen bzw. anhand von kapazitiven Drucksensoren erläutert.

Allgemein werden Mikrofone im Bereich der Consumer-Elektronik, wie z.B. Handys, Hifi-Geräte o.ä., und zunehmend auch im Kraftfahrzeugbereich, z.B. zur Spracheingabe, in extrem hohen Stückzahlen benötigt (ca. 1,3-1,5 Mrd. Stück/Jahr). Neben den bisher favorisierten Lösungen auf Electret-Basis oder in Form von feinmechanischen Konstruktionen mit piezoelektrischer, kapazitiver oder induktiver Signalwandlung finden vermehrt Festkörper-Mikrofone auf Siliziumbasis Eingang in den Markt.

Die bisher bekannten Herstellungsprozesse für derartige Festkörper-Mikrofone sind allerdings recht aufwändig. Der grundsätzliche Aufbau eines Festkörper-Mikrofons sieht eine Perforation von der Waferrückseite unter einer freitragenden Membran der Wafervorderseite vor, wobei diese Perforation zum einen Gasdämpfungsmechanismen bereitstellt. Zum anderen gestattet die Perforation beispielsweise bei Face-down-Montage auf einer Platine oder einem Hybrid mittels Flip-Chip-Verbindungstechniken auch einen Schalldurchtritt im Falle einer Beschallung von der Waferrückseite her.

Außerdem stellen die Öffnungen einen Druckausgleich bereit, um bei Veränderungen des atmosphärischen Umgebungsdrucks die Membran nicht bereits vorauszulenken. Wird die Membran durch Schall ausgelenkt, kommt es unter der Membran zu einer Kompression des sich dort zwischen Membranunterseite und Gegenplattenoberseite befindlichen Gases von annähernd atmosphärischem Druck, was eine Gasströmung durch die Poren der Gegenplatte zur Folge hat. Diese Gasströmung entzieht dem schwingungsfähigen System Energie und sorgt bei entsprechender Dimensionierung so für eine Gasdämpfung der Membranbewegung und einen gleichmäßigen Verlauf der spektralen Kennlinie des Mikrofons. Unabhängig von der Funktion als Schallwandler stellt ein derartiges Bauelement stets auch einen Relativdrucksensor dar, d.h. Druckdifferenzen zwischen Membranvorder- und -rückseite führen zu einer entsprechenden Membranauslenkung, wobei bei einem Drucksensor die Gasfluidik im Spalt unter der Membran in der Regel nur eine untergeordnete Rolle spielt. Ein Mikrofon der beschriebenen Bauart ist also ein Relativdrucksensor erweitert durch eine funktionale Gasfluidik und Zusatzvolumina und Ausgleichsöffnungen, die das Drucksensor-Bauelement letztlich zu einem Schallwandler machen.

Bei einem kapazitiven Mikrofon dient die Gegenplatte unter der Membran bzw. der Bulk-Wafer als elektrische Gegenelektrode zur Membran, d.h. Veränderungen der Kapazität über den aus der Membran und der Gegenelektrode gebildeten Luftspalt-Kondensator werden in geeigneter Weise detektiert und in ein elektrisches Signal gewandelt, das die Membranauslenkung und damit den aufgenommenen Schallpegel wiedergibt.

Aus dem Stand der Technik sind verschiedene Beschreibungen zum Aufbau von Drucksensoren oder Mikrofonen mittels mikromechanischer Prozesse, z.B. der Erzeugung von Membranen und Kavernen bekannt. Beispielhaft zu nennen wären dabei die EP 969694 A1, US 6140689 A, US 2004/0259286 A1, US 6816301 B1 und US 6790699 B2.

Das erfindungsgemäße mikromechanische Bauelement mit den Merkmalen des Anspruchs 1 bzw. das Herstellungsverfahren nach Anspruch 11 weisen den Vorteil auf, dass sie einen einfachen und sicheren Prozess zur Herstellung von mikromechanischen Bauelementen, insbesondere kapazitiven Siliziummikrofonen, vorschlagen, der sich besonders kostengünstig umsetzen lässt.

Die der vorliegenden Erfindung zugrunde liegende Idee besteht darin, dass unabhängig von einer konkreten Auslegung eines solchen Bauelements hinsichtlich der Dimensionierung der Membran, der Dicke der Gegenplatte, dem Durchmesser und der Anzahl der Perforationsöffnungen oder dem konkret eingesetzten elektrischen Signalwandlungsprinzip einige grundsätzliche Verfahrensschritte erforderlich sind:
- eine Perforation von der Waferrückseite für den Gasaustausch unter der Membran bzw. für rückseitige Beschallung der Membran bzw. als Druckausgleichsöffnungen, d.h. Anlegen von Öffnungen auf der Waferrückseite durch Ätzen, vorwiegend anisotropes Ätzen;
- Anlegen und elektrische Kontaktierung geeigneter Auswertemittel auf der Membran bzw. der Membran selbst im Falle einer kapazitiven Detektion;
- Anlegen und elektrische Kontaktierung einer Gegenelektrode im Fall kapazitiver Detektion;
- Erzeugung einer freitragenden Membran auf der Wafervorderseite, d.h. Anlegen der Membran und Einsatz geeigneter Opferschichtätztechnik, vorzugsweise isotroper Opferschichtätztechnik, zur Freilegung bzw. Unterätzung der Membran; und
- ggfs. Vereinzelung durch Sägen und Verpacken.

Schwer beherrschbare Prozessschritte werden erfindungsgemäß weitestgehend vermieden, ebenso wie exotische Prozessschritte, wie z.B. ein Aufkleben von Wafern auf Trägerwafer o.ä.. Kernstück des Prozesses ist eine Trenchätzung von der Waferrückseite in Verbindung mit einer darauf folgenden Opferschichtätzung unter der späteren Membran, welche eine äußerst hohe Selektivität gegenüber dem Grundmaterial Silizium sowie Silizium-basierten dielektrischen Schichten aufweist. Dank dieser sehr hohen Selektivität wird erreicht, dass ohne weitere Schutzmaßnahmen des umgebenden Siliziums die Opferschicht-Ätztechnik durchgeführt werden kann, ohne die bestehenden Siliziumstrukturen oder funktionale dielektrische Schichten anzugreifen, was den Gesamtprozess nochmals deutlich vereinfacht.

Der erfindungsgemäße Prozessablauf ist uneingeschränkt IC-prozesskompatibel, so dass auch eine elektrische Auswerteschaltung zur Signalwandlung und Signalverarbeitung auf der Wafervorderseite integriert werden kann, wo dies aufgrund der vorgesehenen Applikation sinnvoll erscheint.

Alle eingesetzten Mikrostrukturierungsverfahren mit Ausnahme der HF-Dampfätzung sind nämlich grundsätzlich gänzlich kompatibel zu ebenfalls auf dem Wafer vorhandenen integrierten Schaltkreisen. Da die optionelle HF-Dampfätzung von der Waferrückseite her stattfindet, erreicht sie die empfindlichen Strukturen der Wafervorderseite nicht, wenn prozesstechnisch für eine Medientrennung Waferrückseite/Wafervorderseite gesorgt ist, beispielsweise durch eine geeignete Waferaufnahme beim HF-Dampfätzen mit O-Ringdichtungen zur Wafervorderseite und/oder Waferrückseite. Technische Lösungen, die diese Medientrennungen garantieren können, sind grundsätzlich bekannt bzw. dem mit der HF-Dampfätztechnik und den entsprechenden Ätzapparaturen vertrauten Fachmann geläufig.

In den Unteransprüchen finden sich vorteilhafte Weiterbildungen und Verbesserungen des jeweiligen Gegenstandes der Erfindung.

Die Membran ist entweder gewölbt oder eben über der Vorderseite des Substrats vorgesehen. Der von der Membran gebildete Stufenwinkel kann unter bestimmten Umständen eine Änderung im Spannungszustand der Membran erzeugen, wodurch bei bestimmten Anwendungen beispielsweise die Membranvorauslenkung zu groß werden kann.

Eine Wölbung oder Membranvorauslenkung tritt dann auf, wenn die Opferschicht auf ein unstrukturiertes Substrat aufgebracht und danach strukturiert wird. Eine Wölbung der Membran oder Membranvorauslenkung kann dadurch vermieden werden, dass beispielsweise mittels anisotroper Ätztechnik im Substrat oder in einer auf einem Substrat vorgesehenen Elektrodenschicht, welche als untere Elektrode dient, ein Bereich vorgesehen wird, in den hinein die Opferschicht abgesenkt werden kann, so dass im weiteren Prozess keine Stufe mehr in der darüber liegenden Membranschicht ausgebildet wird. Damit ist das Problem des Stufenwinkels bei der Membranaufhängung beseitigt, und die nachfolgende Abscheidung der Membranschichten erfolgt in einer Ebene ohne Topographieausbildung. Zur Umsetzung sollte vorzugsweise vermieden werden, dass sich die Vertiefung in der unteren Elektrode in einer ausgeprägten Topografie über den gesamten Wafer nach der Abscheidung der Opferschicht von vorzugsweise Si₁₋ₓGeₓ äußert. In diesem Fall wäre eine Planarisierung mittels eines CMP-Schrittes nach der Opferschichtabscheidung unabdingbar. Dies lässt sich vermeiden durch einen selektiven Wachstumsprozess von Silizium-Germanium bzw. Germanium auf Silizium, nicht aber auf Si0₂ worauf kein Wachstum dieser Ge-haltigen Materialien stattfinden soll. Eine selektive Abscheidung der Opferschicht hat zum Vorteil, dass nur die vorgesehene Vertiefung im Substrat bzw. in der Gegenelektrode beschichtet wird und die umliegenden, dielektrisch bedeckten Bereiche kein Schichtwachstum erfahren. Dazu werden die Polysilizium-Bereiche außerhalb der Vertiefung mit einer dielektrischen Schicht beispielsweise einer Oxidschicht bedeckt. Vorteilhafterweise ist im Prozessfluss zur Herstellung eines Mikrofons oder Drucksensors ohnehin schon eine Oxidschicht zur elektrischen Isolation vorgesehen. Der in der Polysilizium-Gegenelektrode beziehungsweise im Substrat vertiefte, nicht mit Oxid bedeckte Bereich wird wegen besserer Aufwachsbedingungen (Silizium als Startmedium) mit Silizium-Germanium bzw. mit reinem Germanium bedeckt. Bei geeigneter Prozessführung (Abscheidetemperatur, Druck) kann die Selektivität dieses selektiven Wachstumsprozesses noch gefördert werden. Der Nachteil des Stufenwinkels in der Membranaufhängung sowie kostenintensive Nachbehandlungsschritte, wie z.B. CMP (Chemisch mechanisches Polieren) bei Versenkung der Opferschicht ohne selektives Wachstum, werden damit gemäß diesem Aspekt überwunden.

Gemäß einer bevorzugten Weiterbildung führen die Perforationsöffnungen in eine Kaverne, die in der Rückseite des Substrats unter der Membran vorgesehen ist.

Gemäß einer weiteren bevorzugten Weiterbildung besteht die Membran aus einer einzigen leitfähigen Schicht.

Gemäß einer weiteren bevorzugten Weiterbildung besteht die Membran aus einer oberen leitfähigen Schicht und einer unteren ersten dielektrischen Schicht.

Gemäß einer weiteren bevorzugten Weiterbildung weist das Substrat ein Wafersubstrat, eine darauf befindliche zweite dielektrische Schicht und eine darauf befindliche Schicht aus Siliziummaterial auf wobei Perforationsöffnungen durch die zweite dielektrische Schicht verlaufen, wobei die zweite dielektrische Schicht das Wafersubstrat und die darauf befindliche Schicht aus Substratmaterial außerhalb der Perforationsöffnungen elektrisch voneinander isoliert.

Gemäß einer weiteren bevorzugten Weiterbildung ist zwischen dem Substrat und der Membran eine dritte dielektrische Schicht auf der Vorderseite des Substrats vorgesehen, die vorzugsweise als sehr dünne Schicht (< 500 nm, besonders bevorzugt < 100 nm) ausgeführt ist und als Diffusionssperre gegen eine thermische Ausdiffusion von Opferschichtmaterial, insbesondere von Germanium, wirken soll.

Gemäß einer weiteren bevorzugten Weiterbildung ist das dämpfende Medium ein Gas.

### ZEICHNUNGEN

Ausführungsbeispiele der Erfindung sind in den Zeichnungen dargestellt und werden in der nachfolgenden Beschreibung näher erläutert.
- Fig. 1A-G: zeigen schematische Querschnittsansichten der wesentlichen Herstellungsschritte eines mikromechanischen Bauelements in Form eines kapazitiven Mikrofons gemäß einer nicht beanspruchten ersten Ausführungsform;
- Fig. 2A-H: zeigen schematische Querschnittsansichten der wesentlichen Herstellungsschritte eines mikromechanischen Bauelements in Form eines kapazitiven Mikrofons gemäß einer nicht beanspruchten zweiten Ausführungsform;
- Fig. 3A-H: schematische Querschnittsansichten der wesentlichen Herstellungsschritte eines mikromechanischen Bauelements in Form eines kapazitiven Mikrofons oder Drucksensors gemäß einer nicht beanspruchten dritten Ausführungsform;
- Fig. 4A-I: schematische Querschnittsansichten der wesentlichen Herstellungsschritte eines mikromechanischen Bauelements in Form eines kapazitiven Mikrofons oder Drucksensors gemäß einer nicht beanspruchten vierten Ausführungsform;
- Fig. 5A-H: schematische Querschnittsansichten der wesentlichen Herstellungsschritte eines mikromechanischen Bauelements in Form eines kapazitiven Mikrofons oder Drucksensors gemäß einer fünften Ausführungsform der vorliegenden Erfindung;
- Fig. 6A-J: schematische Querschnittsansichten der wesentlichen Herstellungsschritte eines mikromechanischen Bauelements in Form eines kapazitiven Mikrofons oder Drucksensors gemäß einer sechsten Ausführungsform der vorliegenden Erfindung; und
- Fig. 7A-L: schematische Querschnittsansichten der wesentlichen Herstellungsschritte eines mikromechanischen Bauelements in Form eines kapazitiven Mikrofons oder Drucksensors gemäß einer nicht beanspruchten siebenten Ausführungsform.

### BESCHREIBUNG DER AUSFÜHRUNGSBEISPIELE

In den Figuren bezeichnen gleiche Bezugszeichen gleiche oder funktionsgleiche Komponenten.

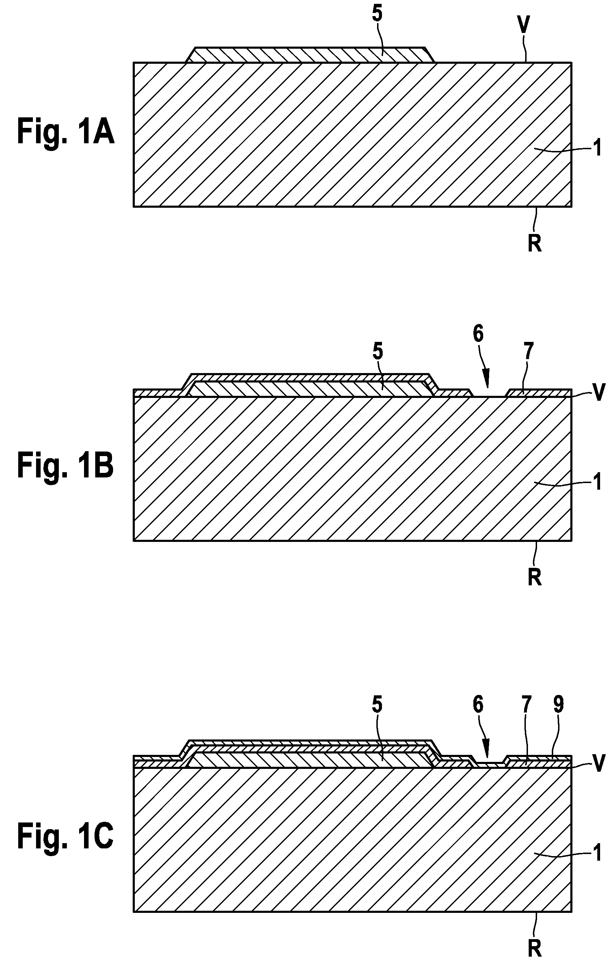

Fig. 1A-G zeigen schematische Querschnittsansichten der wesentlichen Herstellungschritte eines mikromechanischen Bauelements in Form eines kapazitiven Mikrofons oder Drucksensors gemäß einer nicht beanspruchten ersten Ausführungsform der vorliegenden Erfindung.

In Fig. 1A bezeichnet Bezugszeichen 1 ein Siliziumwafersubstrat. In einem ersten Prozessschritt wird auf dem Siliziumwafersubstrat 1 eine Opferschicht 5 aus SiGe oder Ge, vorzugsweise aus Si₁₋ₓGeₓ mit x=0,1-0,8, besonders bevorzugt mit x=0,2-0,5, auf der Wafervorderseite V abgeschieden. Die Opferschicht 5 wird anschließend im späteren Membranbereich zu einer Insel strukturiert bzw. in einer Vielzahl von Membranbereichen zu einer Vielzahl von Inseln entsprechend einer Vielzahl von Bauelementen strukturiert. Die Schichtdicke der Opferschicht 5 kann einige wenige µm betragen und definiert den späteren Luftspalt zwischen der späteren Membran und der Gegenplatte, welche den Kondensator bei der kapazitiven Auswertung des Mikrofons bilden.

Gemäß Fig. 1B wird dann eine dielektrische Schicht 7 auf der Wafervorderseite V und über der inselförmigen Opferschicht 5 abgeschieden oder durch thermische Oxidation aufgewachsen und derart strukturiert, dass zumindest der jeweilige inselförmigen Bereich der Opferschicht 5 komplett überspannt wird. Danach wird in der dielektrischen Schicht 7 ein Fenster 6 geöffnet, durch das später das Siliziumwafersubstrat 1 durch geeignete Metallschichten elektrisch kontaktiert werden kann.

Es ist möglich und vorteilhaft, die dielektrische Schicht 7 überall außerhalb der Fenster 6 stehen zu lassen, da sie eine elektrische Isolierung und Passivierung darstellt, auf der später beispielsweise metallische Leiterbahnen und Kontaktierungen ausgeführt werden können, die vom darunter liegenden Siliziumwafersubstrat 1 isoliert sein müssen. Insbesondere eignet sich diese dielektrische Schicht 7 als Isolation einer Kontaktierung und eines elektrischen Anschlusses des Membranbereichs über geeignete Leiterbahnen, die isoliert zum Siliziumwafersubstrat 1 geführt werden sollen.

Als Material für die dielektrische Schicht 7 eignet sich vorzugsweise zugverspanntes Siliziumoxid, ein Siliziumoxynitrid oder auch ein Siliziumnitrid. Die Schicht 7 sollte eine Zugspannung aufweisen, da sie später auch einen Teil der Mikrofonmembran bilden soll und diese möglichst nicht unter Druckspannung stehen sollte, um ein Ausbuckeln bzw. Ausknicken der Membran zu vermeiden. Unter Inkaufnahme der letztgenannten Nachteile kann jedoch auch ein (druckverspanntes) thermisch aufgewachsenes Siliziumoxid (SiO₂) verwendet werden, was Vorteile bietet hinsichtlich einer besonders hochwertigen elektrischen Isolation durch das thermische Oxid.

Wie in Fig. 1C dargestellt, wird anschließend eine elektrisch leitfähige Schicht 9 über der gesamten Struktur abgeschieden und derart strukturiert, dass sie den Bereich der späteren Membranen und die späteren elektrischen Kontakte in den Fenstern 6 überspannt. Diese elektrisch leitfähige Schicht 9 kann durch ein Metall, beispielsweise Al, AlSi, AlCu, AlSiCu, W, WTi, WTi/Au, Cr/Au, Pt, Ni, Ni/Au usw., oder alternativ durch ein Metallsilizid, z.B. WSi, AlSi, PtSi usw., oder alternativ eine Schichtfolge von einer unteren Polysiliziumschicht oder Polysilizium-Germanium-Schicht mit einer darüber befindlichen Metallschicht, z.B. Al, W, WTi, Au, Pt, ... ausgebildet werden. Es ist auch möglich, als elektrisch leitfähige Schicht 9 eine Schicht aus Polysilizium oder Polysilizium-Germanium abzuscheiden und so zu strukturieren, dass nur der Bereich der späteren Membran überspannt wird, und darüber hinaus eine Metallschicht abzuscheiden und derart zu strukturieren, dass das Metall nur noch in Kontaktbereichen der Fenster 6 und in Form von so genannten Leiterbahnen übrig bleibt. Im letzteren Fall hätte man also eine spätere Membran, die nur noch aus der dielektrischen Schicht 7 und einer elektrisch leitfähigen Schicht 9 aus Polysilizium bzw. Polysilizium-Germanium gebildet wird, wobei gegebenenfalls auch die dielektrische Schicht 7 optional nachfolgend noch unter dem die Membran bildenden Bereich der leitfähigen Schicht 9 entfernt werden könnte, wobei das Metall nur noch im Bereich der Leiterbahnen und der Kontaktierungen vorhanden bleibt.

Besonders einfach und daher vorteilhaft ist das Vorsehen einer leitfähigen Schicht 9 aus Metall, die sowohl die Membranoberseite als auch den Bereich der Leiterbahnen und Kontakte bildet, da diese Schicht 9 nur abgeschieden und in einem einzigen Prozessschritt strukturiert werden kann, was auch besonders kostengünstig ist. Im letzteren Fall wird die spätere Membran aus der dielektrischen Schicht 7 und der darüber liegenden elektrisch leitfähigen Schicht 9 aus Metall gebildet, wobei die dielektrische Schicht 7, wie gesagt, zuletzt optional auch noch unter der elektrisch leitfähigen Schicht 9 aus Metall entfernt werden könnte, falls das betreffende Metall für sich betrachtet ausreichend gute mechanische Eigenschaften besitzt. Da viele in der Halbleitertechnik eingesetzte Metallisierungen (z.B. Alu oder Alu-Legierungen) materialintrinsische Hysterese-Effekte aufweisen, sind solche Bauelemente nur für Kleinsignalanwendungen, d.h. Arbeitssituationen unter geringen mechanischen Auslenkungen geeignet. Ein Einsatz als Drucksensor scheidet damit aus; das Bauteil kann dann nur als Mikrofon oder Schallwandler eingesetzt werden.

Des Weiteren ist es möglich, über der Schichtfolge von der dielektrischen Schicht 7 und der leitfähigen Schicht 9 eine (nicht gezeigte) Passivierungsschicht abzuscheiden und derart zu strukturieren, dass sie nur die Fenster 6 zum Kontaktieren der elektrisch leitfähigen Schicht 9 offen lässt. Als Passivierungsschicht eignen sich abgeschiedene Schichten aus SiN, Si₃N₄ oder SiC. Diese Schichten können ebenso wie oxidische Siliziumschichten mit Plasmaätzverfahren im Bereich der späteren Metallkontakte lokal entfernt werden, um ein späteres Drahtbonden bzw. eine Flip-Chip-Verbindungstechnik zu den Metallkontakten zu gestatten. Wird als Metall ein nicht korrodierendes Materialsystem, wie z.B. Au, Pt, Ag oder WTi/Au, Cr/Au, Cr/Ni/Au usw. eingesetzt, kann die Passivierung ohne Nachteil für die Stabilität des Mikrofons im späteren Einsatz auch entfallen. Wird Al oder eine Al-Legierung als Metallisierung verwendet, empfiehlt sich die Flip-Chip-Montagetechnik "face-down", um die Chipvorderseite mittels polymerer Unterfüller (Underfiller) vor korrosiven Umgebungsmedien zu schützen.

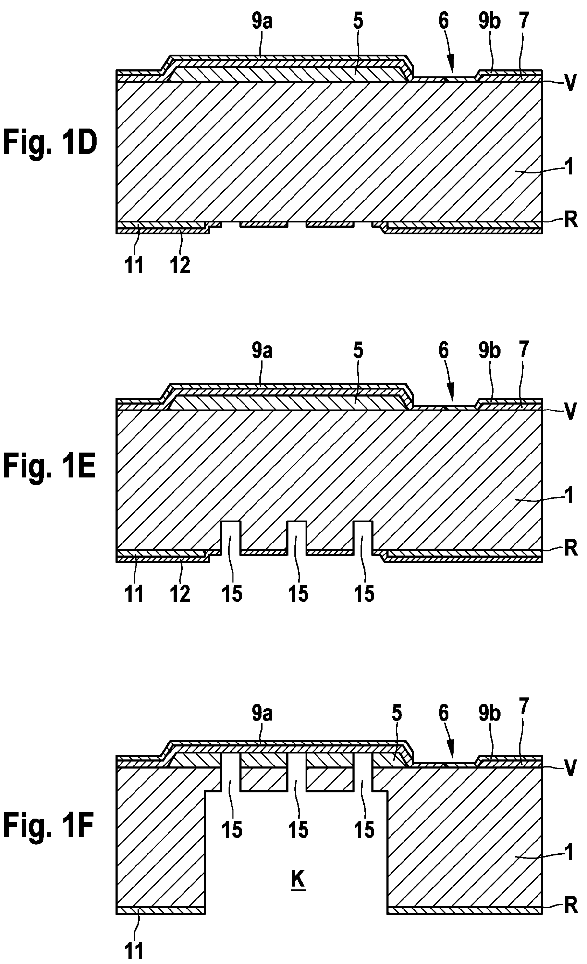

Im nächsten Prozessschritt, der in Fig. 1D illustriert ist, wird die leitfähige Schicht 9 in einen Bereich 9a zum elektrischen Anschluss bzw. Ausbildung der späteren Membran und einen Bereich 9b zum elektrischen Anschluss des Wafersubstrats 1 strukturiert. Zur Vorbereitung eines zweitstufigen Trenchätzprozesses auf der Waferrückseite R wird dann zunächst eine erste dielektrische Maskierschicht 11 als so genannte Hartstoffschicht aus Siliziumoxid oder Siliziumoxynitrid aufgebracht und derart photolithographisch strukturiert, das damit die späteren Kavernen K unter den Mikrofonmembranen definiert werden. Über der ersten Maskierschicht 11 wird anschließend eine weitere Maskierschicht 12 aus dickem Photolack aufgebracht und derart strukturiert, dass damit spätere Perforationslöcher 15 definiert werden.

Fig. 1D zeigt den Prozesszustand mit den beiden rückseitig aufgebrachten Maskierschichten 11, 12, wobei das Siliziumwafersubstrat 1 im Bereich der späteren Perforationslöcher 15 freigelegt ist.

Anschließend wird gemäß Fig. 1E beispielsweise mit einem Verfahren, wie es aus der DE 42 41 045 C2 bekannt ist, damit begonnen, die Perforationslöcher 15 mittels der dicken Maskierschicht 12 aus Photolack bis zu einer gewissen Tiefe in das Siliziumwafersubstrat 1 von der Waferrückseite R her einzuätzen.

Die Perforationslöcher 15 bekommen somit einen gewissen Vorsprung gegenüber einer zweiten Ätzfront, welche entsteht, wenn nach dem Entfernen der Maskierschicht 12 aus Photolack nunmehr mittels der dadurch freigelegten Maskierschicht 11 aus Hartstoff weiter geätzt wird. Es läuft also eine breite Ätzfront in die Tiefe, die die Geometrie der Kavernen K unter den späteren Mikrofonmembranen definiert, wobei dieser "Hauptätzfront" diejenigen Ätzfronten vorauslaufen, die die Perforationslöcher 15 definieren. Dieser Ätzvorgang wird so lange durchgeführt, bis die Perforationslöcher 15 durch die Opferschicht 5 auf die dielektrische Schicht 7 auf der Wafervorderseite V getrieben werden und darauf schließlich stoppen bzw. einen annähernden Ätzstopp erfahren. Dieser Zustand ist in Fig. 1F dargestellt.

Um nun die Membranen M freizulegen, findet eine Ätzung von der Waferrückseite R her mit dem Prozessgas Chlortrifluorid ClF₃ oder einem anderen Gas, beispielsweise ClF₅, BrF₃, BrF₅, XeF₂ oder IF₅ bzw. IF₇, statt, wobei ein Druck von beispielsweise 5 Pa bis 1000 Pa, bevorzugt 10 Pa bis 100 Pa, sowie eine Wafertemperatur von -30°C bis +40°C, vorzugsweise -20°C, herrscht. Unter diesen Bedingungen wird die Opferschicht 5 unter der Membran M durch die Perforationslöcher 15 von der Waferrückseite R her selektiv gegenüber Silizium und gegenüber dielektrischen, Silizium-basierten Schichten, wie z.B. Siliziumoxid oder Siliziumoxynitrid, geätzt, ohne dass es zu deren Passivierung noch weiterer Maßnahmen bedürfte.

Die Selektivität der Ätzung von SiGe gegenüber Si beträgt unter den angegebenen Prozessbedingungen hinsichtlich Schichtzusammensetzung und Ätzparametern typischerweise 4000:1 bis 10000:1, so dass die Opferschicht 5 unter der Membran M durch die Perforationslöcher 15 hindurch komplett entfernt werden kann, ohne die funktionalen Strukturteile aus Silizium oder die funktionalen Dielektrika merklich anzuätzen.

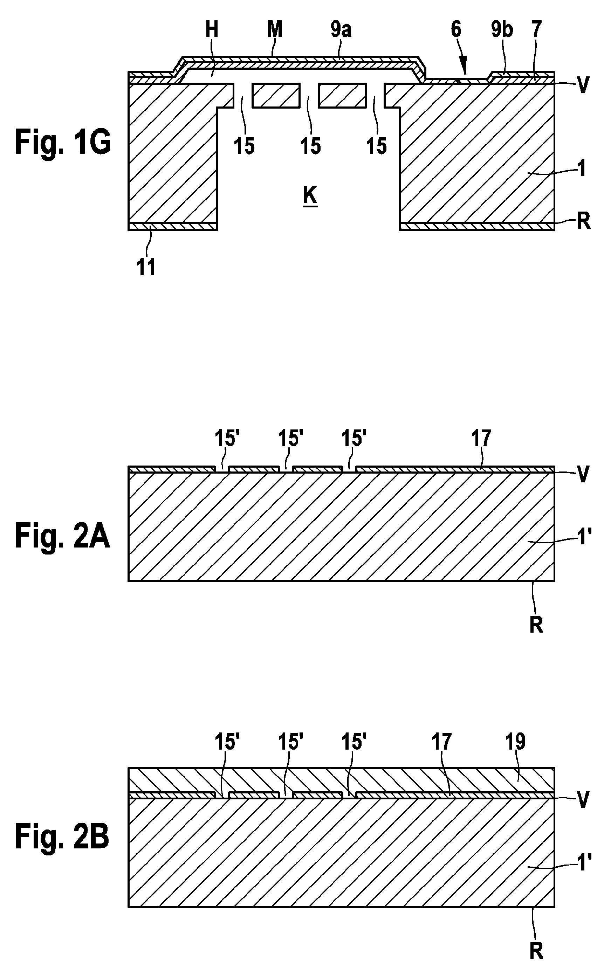

Fig. 1G zeigt das Resultat nach Abschluss der Opferschichtätzung, den fertig prozessierten Wafer 1 mit den freitragenden komplett unterätzten Mikrofonmembranen M und den darunter befindlichen Hohlräumen H zwischen Substrat 1 und Membran M.

Nach Abschluss der Opferschichtätzung kann der fertig prozessierte Wafer 1 mit seiner Waferrückseite R auf eine Schutzfolie, eine so genannte Sägefolie, platziert und anschließend durch Sägen zu Einzelchips vereinzelt werden. Dabei verhindert die Schutzfolie auf der Waferrückseite R, dass Wasser oder Sägeschlamm in die Rückseitenkavernen und in den Spalt zwischen Membran M und perforierter Gegenplatte aus dem Siliziumwafersubstrat 1 eindringen kann, was später die Funktion des Mikrofons beeinträchtigen könnte. Nach dem Sägen, Reinigen und Trocknen kann die Trägerfolie expandiert und können die Einzelchips von der nunmehr gereinigten und getrockneten Folie abgepflückt und montiert werden, beispielsweise in individuellen Gehäusen oder auf einer Platine.

Es ist auch möglich, bei entsprechender Vorbehandlung der Anschlußpads der Wafervorderseite mit Underbump-Metallisierung und Aufbringung von Lötbumps usw. diese Einzelchips mittels Flip-Chip-Technik "face-down" auf einer Platine oder einem Hybrid zu montieren. Diese Montagetechnik schützt die empfindliche Membran und die Wafervorderseite, insbesondere das Metall der Wafervorderseite, vor Umgebungseinflüssen. Die Beschallung erfolgt in diesem Fall von der Rückseite her durch die Perforationslöcher 15 hindurch.

Fig. 2A-H zeigen schematische Querschnittsansichten der wesentlichen Herstellungsschritte eines mikromechanischen Bauelements in Form eines kapazitiven Mikrofons oder Drucksensors gemäß einer zweiten Ausführungsform der vorliegenden Erfindung.

Bei der nicht beanspruchten zweiten Ausführungsform der vorliegenden Erfindung werden kritische Dimensionen der unteren Gegenplatte unter der Mikrofonmembran, insbesondere ihre Dicke und die Durchmesser der Perforationsöffnungen, nicht über ein Differenzätzen von der Waferrückseite her definiert wie bei der ersten Ausführungsform, sondern durch einen Wafervorderseitenprozess, der eine genauere Einstellung dieser Dimensionen ermöglicht.

Gemäß Fig. 2A wird auf einem Siliziumwafersubstrat 1' eine dielektrische Schicht 17 beispielsweise aus Siliziumoxid auf der Wafervorderseite V abgeschieden bzw. thermisch aufoxidiert. In dieser dielektrischen Schicht 17 werden Maskenöffnungen 15' entsprechend späteren Perforationslöchern in der späteren Gegenplatte als Fenster lithographisch definiert und geöffnet.

In einem nächsten Schritt, der in Fig. 2B illustriert ist, wird eine Polysiliziumschicht 19 auf der Wafervorderseite V ganzflächig abgeschieden. Insbesondere wird dabei nach Aufbringung einer nicht gezeigten Startpolysiliziumschicht in einem LPCVD-Reaktor diese Schicht in einem Epitaxie-Reaktor mit hoher Abscheiderate auf die gewünschte Dicke von beispielsweise 10 bis 30 µm verstärkt. Die raue Oberfläche der epitaktischen Polysiliziumschicht 19 kann nachfolgend durch Schleifen und Polieren planarisiert und die epitaktische Polysiliziumschicht 19 nachfolgend dotiert und damit elektrisch hinreichend leitfähig gemacht werden.

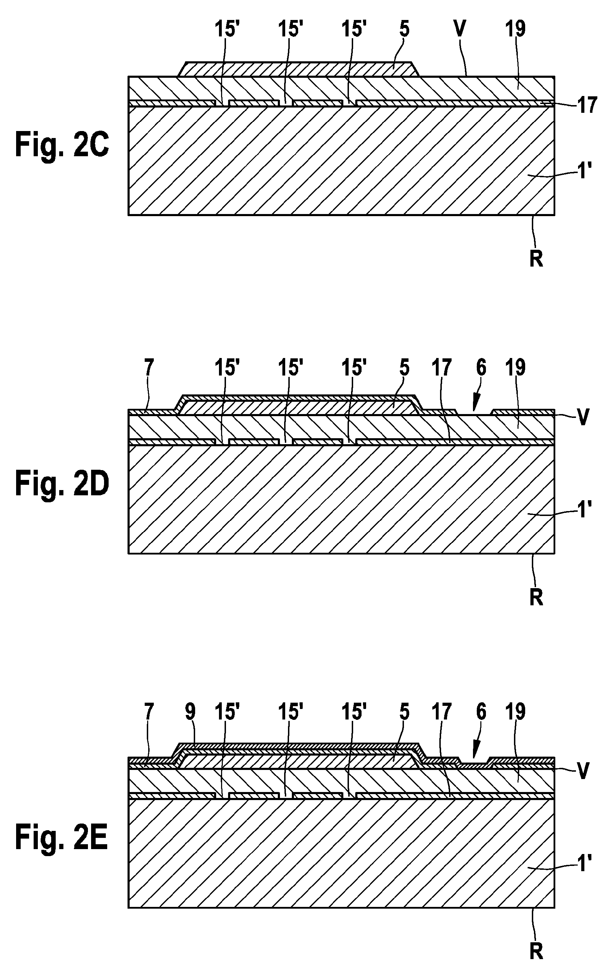

Weiter mit Bezug auf Fig. 2C wird die bereits aus der obigen ersten Ausführungsform bekannte Opferschicht 5 aus SiGe auf der Wafervorderseite V aufgebracht und mittels Photolithographie und Ätzen zu Inseln im Bereich der späteren Membranen strukturiert.

In einem folgenden Prozessschritt, der in Fig. 2D illustriert ist, wird analog zu Fig. 1B die dielektrische Schicht 7 ganzflächig abgeschieden und ein Fenster 6 lithographisch darin strukturiert.

Gemäß Fig. 2E wird dann analog Fig. 1C die elektrisch leitende Schicht 9 über der gesamten Struktur ganzflächig abgeschieden.

Die möglichen Materialien und Varianten für die Schichten 7, 9 sind bei der zweiten Ausführungsform genau dieselben wie bei der oben erläuterten ersten Ausführungsform.

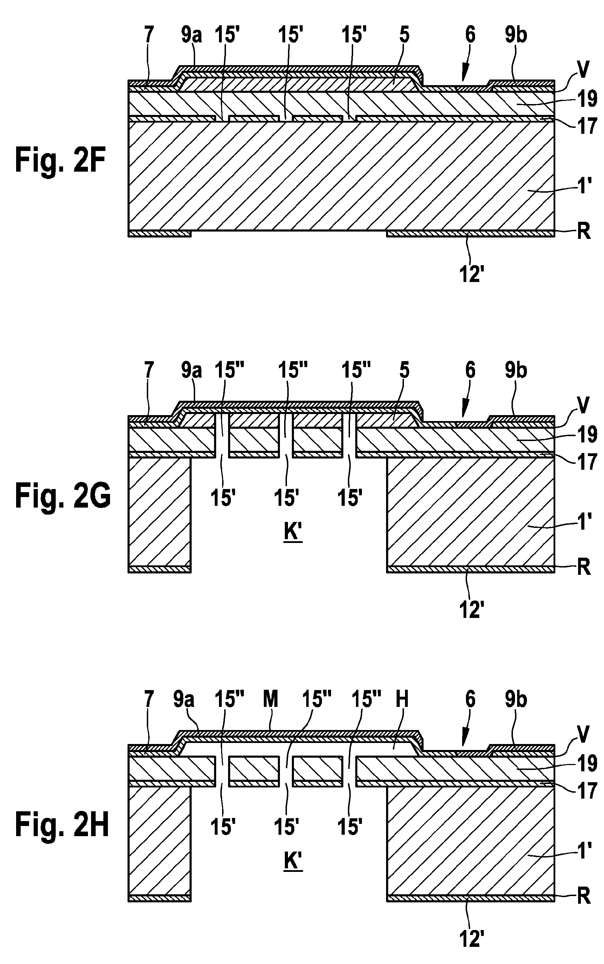

Im nächsten Prozessschritt, der in Fig. 2F illustriert ist, wird die leitfähige Schicht 9 in einen Bereich 9a zum elektrischen Anschluss bzw. Ausbildung der späteren Membran und einen Bereich 9b zum elektrischen Anschluss des Wafersubstrats 1 strukturiert. Weiter mit Bezug auf Fig. 2F wird dann auf der Waferrückseite R eine Maskierschicht 12' aufgebracht, bei der es sich vorzugsweise um eine dicke Lackmaske handelt, die ihrerseits photolithographisch derart strukturiert wird, dass sie die Kaverne K' unter der späteren Membran defmiert. Alternativ kann auch eine Hartstoffschicht verwendet werden z.B. in Form von Siliziumoxid, die vermöge einer Fotolackmaskierung vorstrukturiert und anschließend als die eigentliche Trenchmaske dient.

Im Gegensatz zur obigen ersten Ausführungsform benötigt man bei der zweiten Ausführungsform nur eine einlagige Rückseitenmaskierung mit der Maskierschicht 12', da aufgrund der in der dielektrischen Schicht 17 vordefinierten Maskenöffnungen 15' nur ein einstufiger Tiefenätzprozess erforderlich ist, um sowohl die Kaverne K' als auch die Perforationslöcher 15" zu produzieren.

Mit Bezug auf Fig. 2G erfolgt dann dieser einstufige Tiefenätzprozess zum Trenchen, wobei die Kavernen K' flächig von der Waferrückseite R zur Wafervorderseite V hin getrieben werden. Wie gesagt, kann der Tiefenätzprozess ein Plasmaätzverfahren sein, wie beispielsweise in der DE 4241045 C2 offenbart. Der Tiefenätzprozess stoppt flächig auf der strukturierten dielektrischen Schicht 17 zwischen dem Siliziumwafersubstrat 1' und der epitaktischen Polysiliziumschicht 19 ausgenommen in den Maskenöffnungen 15', wo der Tiefenätzprozess anschließend noch in der epitaktischen Polysiliziumschicht 19 zur Wafervorderseite V hin weiter voranschreitet und die sich an die Maskenöffnungen 15' anschließenden Perforationsöffnungen 15" ausbildet..

Der Ätzprozess stoppt nach dem Durchätzen der epitaktischen Polysiliziumschicht 19 und der Opferschicht 5 auf der dielektrischen Schicht 7 aus Siliziumoxid, Siliziumoxynitrid bzw. Siliziumnitrid, welche einen Teil der späteren Membran M bildet, wie in Fig. 2G zu erkennen ist.

Im abschließenden Schritt, der in Fig. 2H gezeigt ist, wird dann wieder mittels der bereits beschriebenen isotropen Ätzung von der Waferrückseite R her die Opferschicht 5 hochselektiv entfernt, um die Membran M freizulegen und den Hohlraum H zu bilden.

Wie bei der ersten Ausführungsform kann bedarfsweise optional von der Waferrückseite R her auch die dielektrische Schicht 7 im Bereich der Membran M entfernt werden, wenn die elektrisch leitfähige Schicht 9 sich als alleinige Membran eignet, beispielsweise mittels HF-Dampfätzen. In den meisten Fällen ist es aber vorteilhaft und einfacher, die dielektrische Schicht 7 zu erhalten und als Bestandteil der Membran M zu belassen. Damit ist auch ein allfälliges Metallsystem auf der Membran M von seiner Unterseite her gegenüber aggressiver Umgebung geschützt. Dies ist insbesondere dann vorteilhaft und wirksam, wenn das derart gestaltete Siliziummikrofon später "face-down" beispielsweise mittels Flip-Chip-Technologie auf einer Platine oder einem Hybrid montiert und von seiner Rückseite her beschallt wird.

Die Vereinzelung und Montage erfolgt im Übrigen, wie bereits bei der obigen ersten Ausführungsform beschrieben.

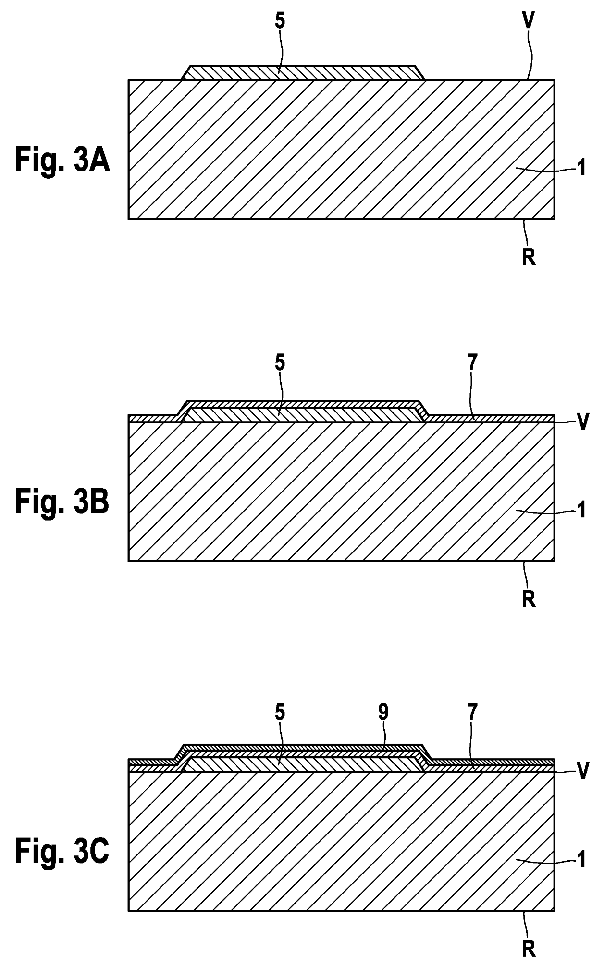

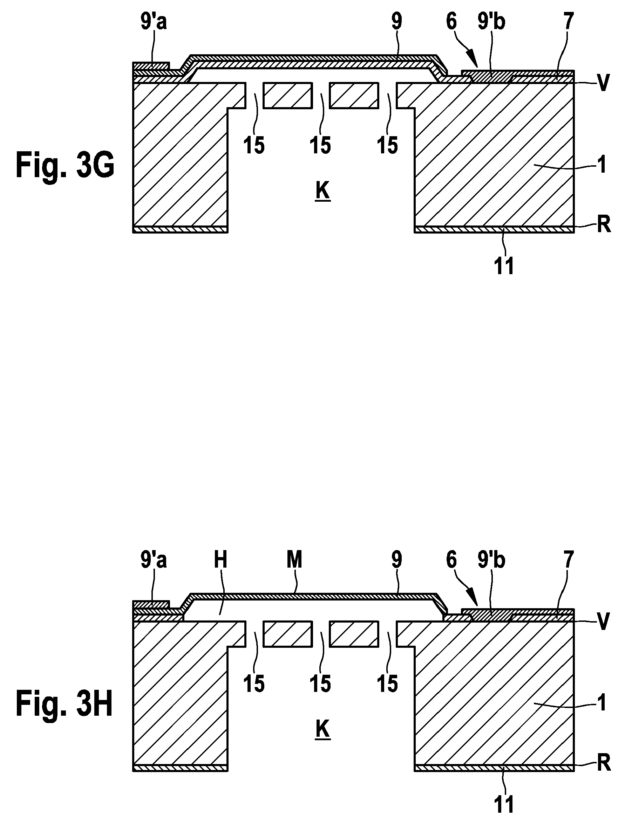

Fig. 3A-H zeigen schematische Querschnittsansichten der wesentlichen Herstellungsschritte eines mikromechanischen Bauelements in Form eines kapazitiven Mikrofons oder Drucksensors gemäß einer nicht beanspruchten dritten Ausführungsform der vorliegenden Erfindung.

Zum Verständnis der nachstehend erläuterten dritten Ausführungsform wird festgehalten, dass es sich bei einem Mikrofon nicht um ein Messgerät im strengen Sinne handelt, sondern um einen Schallwandler, dessen Verhalten durch die Membraneigenschaften, durch die Gasfeder unter der Membran und durch die Gasdämpfung bestimmt wird. Messfehler im prozentualen Bereich, also z.B. Hysteresen aufgrund der Art des gewählten Membranmaterials (z.B. aufgrund der Verwendung von Metallen wie Aluminium oder Al-Legierungen als Bestandteil der druckempfindlichen Membran), spielen dabei nur eine untergeordnete Rolle, insbesondere deshalb, weil ein Mikrofon üblicherweise im Kleinsignalfall - d.h. im Fall kleiner mechanischer Auslenkungen betrieben wird, wo Hysteresen keinen signifikanten Störeffekt beitragen. Anders sieht es dagegen bei einem Drucksensor aus. Hierbei handelt es sich um ein Messinstrument, und die Anforderungen an die Messgenauigkeit sind in der Regel hoch. Drucksensoren sind in ihrer Anwendung auch nicht auf den Kleinsignalfall beschränkt, sondern müssen größere Membranauslenkungen treu in ein elektrisches Signal wandeln. Hysteresen sind dabei in der Regel unzulässig. Aus diesem Grund dürfen als Bestandteile der druckempfindlichen Membran in einem Drucksensor nur hysteresefreie Materialien verwendet werden, beispielsweise Polysilizium, während viele Metalle, beispielsweise Aluminium-Pads und Aluminium-Leiterbahnen, außerhalb der Membranen, und zwar bevorzugt räumlich weit entfernt von der Membran, eingesetzt werden dürfen. Natürlich kann ohne weiteres auch bei einem Mikrofon von der Verwendung solcher Metalle abgesehen und im Sinne der nachfolgenden Beschreibung verfahren werden, zum Beispiel um ein besonders gutes Mikrofon herzustellen.

Diesen Anforderungen trägt die vorliegende dritte Ausführungsform Rechnung, die die Herstellung eines Relativdrucksensors oder qualitativ besonders hochwertigen Mikrofons abgeleitet aus dem obigen Mikrofonprozess schildert.

Sie verwendet als Membranmaterial bevorzugt eine Kombination einer dielektrischen Schicht 7 aus Siliziumoxid und einer leitfähigen Schicht 9 aus Polysilizium. In einer Variante kann die dielektrische Schicht 7 entfernt werden, so dass nur die leitfähige Schicht 9 aus Polysilizium als Membranmaterial verbleibt.

Der Prozessablauf entspricht in seinen wesentlichen Merkmalen demjenigen der oben beschriebenen ersten Ausführungsform. Insbesondere werden, wie aus Fig. 3A-C ersichtlich, zunächst die Opferschicht 5 im inselartigen Membranbereich gebildet und danach die dielektrische Schicht 7 aus Siliziumoxid und danach die leitfähige Schicht 9 aus Polysilizium abgeschieden.

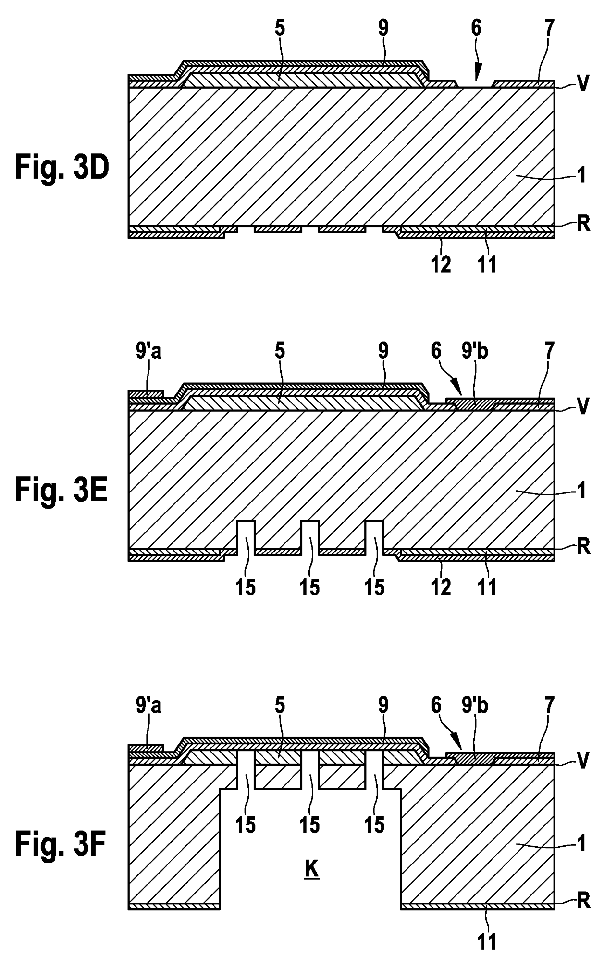

In einem darauf folgenden Prozessschritt, der in Fig. 3D illustriert ist, werden zunächst die leitfähige Schicht 9 aus Polysilizium und danach die freigelegte dielektrische Schicht 7 strukturiert, um in letzterer das Fenster 6 zu bilden, welches den Zugang zum Siliziumwafersubstrat 1 vorsieht.

Erst in einem Prozessschritt, der in Fig. 3E illustriert ist, wird eine weitere leitfähige Schicht abgeschieden, welche im Bereich 9'a die leitfähige Schicht 9 außerhalb des Membranbereichs und im Bereich 9'b das Siliziumwafersubstrat 1 durch das Fenster 6 kontaktiert. Mit anderen Worten wird die weitere leitfähige Schicht komplett vom Membranbereich entfernt und derart strukturiert, dass sie nur im Kontaktbereich als Bereich 9'b und in Bondlands des Sensorelements als Bereich 9'a erhalten bleibt.

Die Prozessschritte gemäß Fig. 3E auf der Waferrückseite sowie 3F und 3G entsprechend den Prozessschritten gemäß Fig. 1E, 1F und 1G.

Schließlich wird gemäß Fig. 3H in einem HF-Ätzschritt noch die dielektrische Schicht 7 im Membranbereich entfernt, so dass die leitfähige Schicht 9 allein die Membran M mit dem darunter befindlichen Hohlraum bildet.

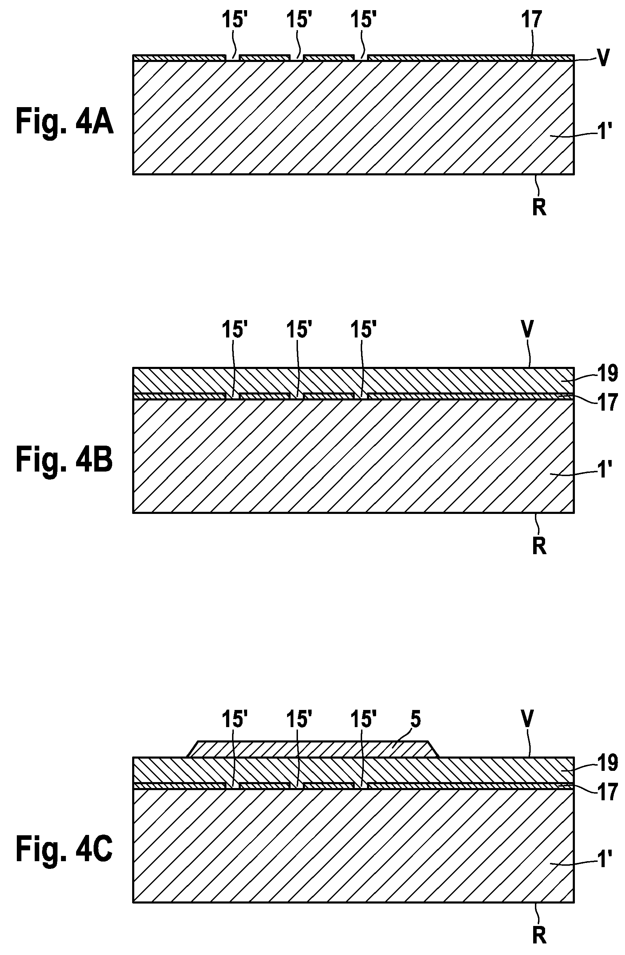

Fig. 4A-I zeigen schematische Querschnittsansichten der wesentlichen Herstellungsschritte eines mikromechanischen Bauelements in Form eines Mikrofons oder Drucksensors gemäß einer vierten nicht beanspruchten Ausführungsform der vorliegenden Erfindung;

Die vierte Ausführungsform ist hinsichtlich der zweiten Ausführungsform eine analoge Abwandlung wie die dritte Ausführungsform hinsichtlich der ersten Ausführungsform.

Die Prozessschritte gemäß Fig. 4A-C entsprechen den Prozessschritten gemäß Fig. 2A-C.

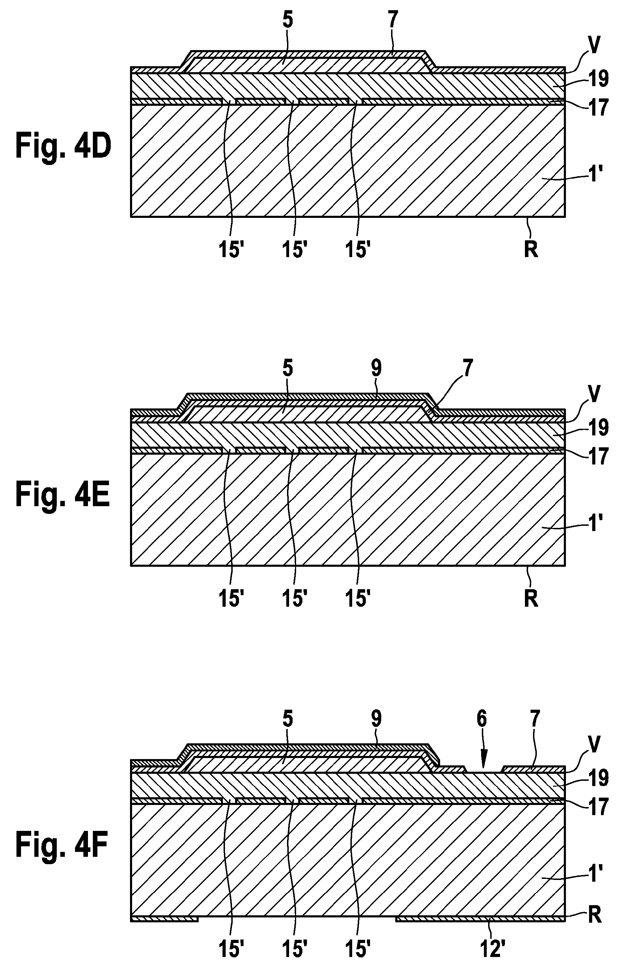

Die Prozessschritte gemäß Fig. 4D und 4E entsprechen hinsichtlich der Vorderseite V den Prozessschritten gemäß Fig. 3B und 3C.

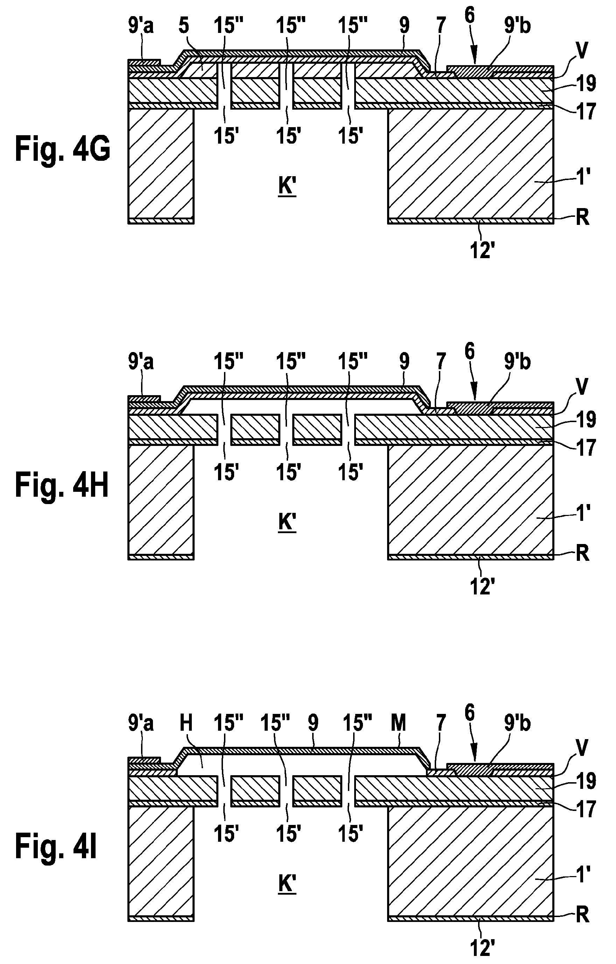

Die Prozessschritte gemäß Fig. 4F,G,H entsprechen hinsichtlich der Waferrückseite R den Prozessschritten gemäß Fig. 2F,G,H. Hinsichtlich der Wafervorderseite V entsprechen sie den Prozessschritten gemäß Fig. 3D,E,F.

Im Prozessschritt gemäß Fig. 4I schließlich wird die dielektrische Schicht 7 im Membranbereich bzw. Hohlraum H durch einen HF-Dampfätzschritt, wie bereits im Zusammenhang mit Fig. 3H erläutert, entfernt.

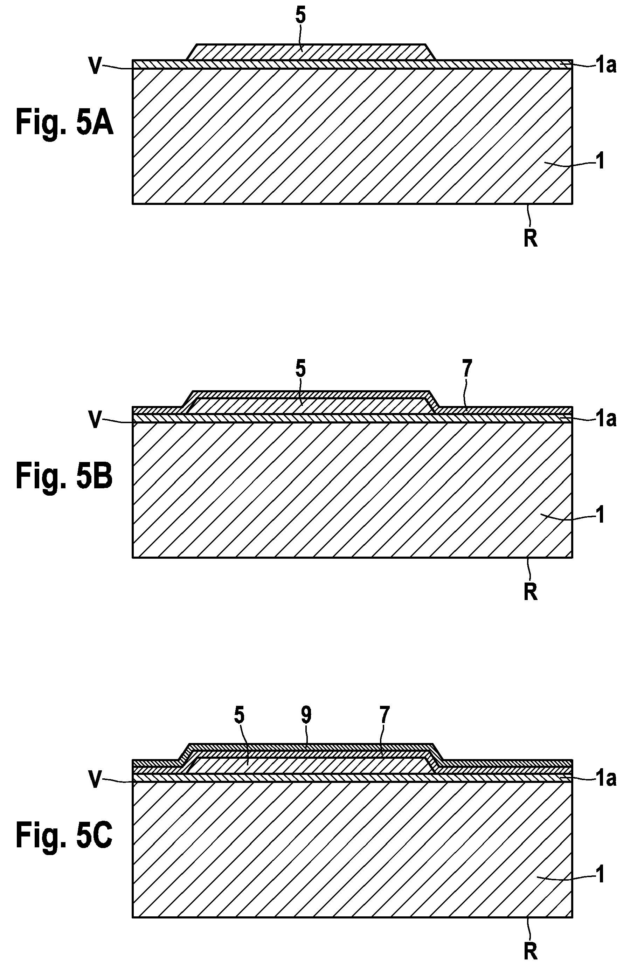

Fig. 5A-H zeigen schematische Querschnittsansichten der wesentlichen Herstellungsschritte eines mikromechanischen Bauelements in Form eines Mikrofons oder Drucksensors gemäß einer fünften Ausführungsform der vorliegenden Erfindung.

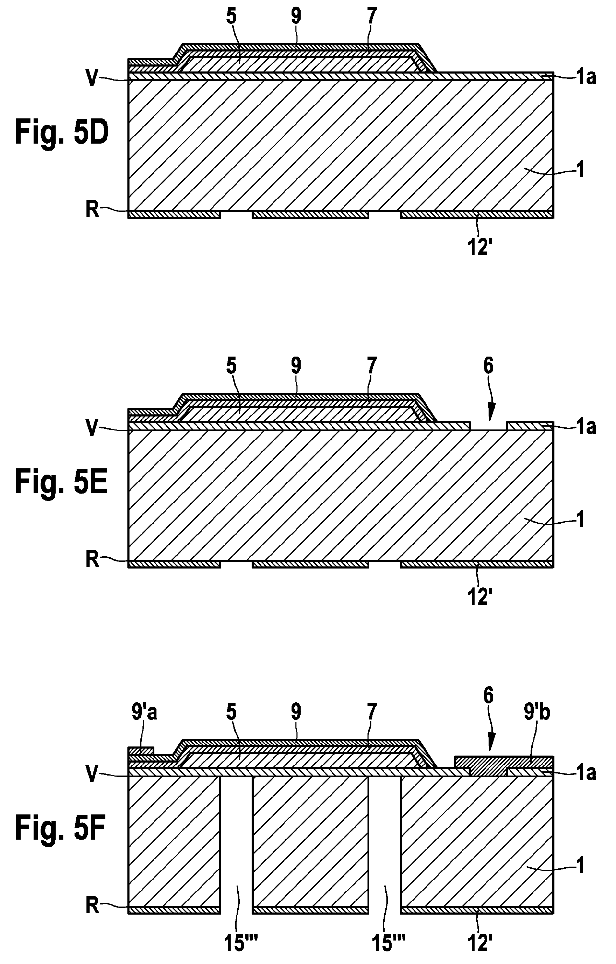

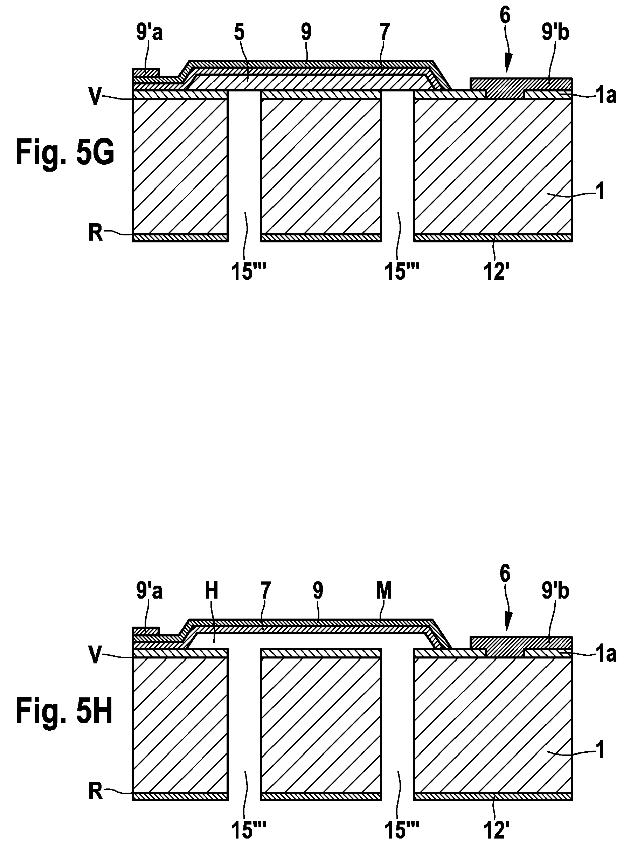

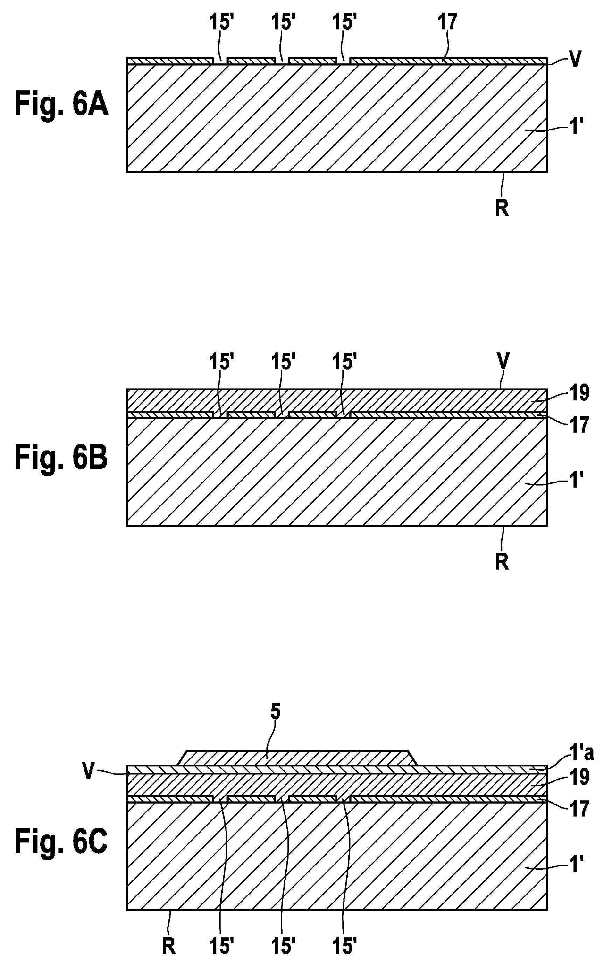

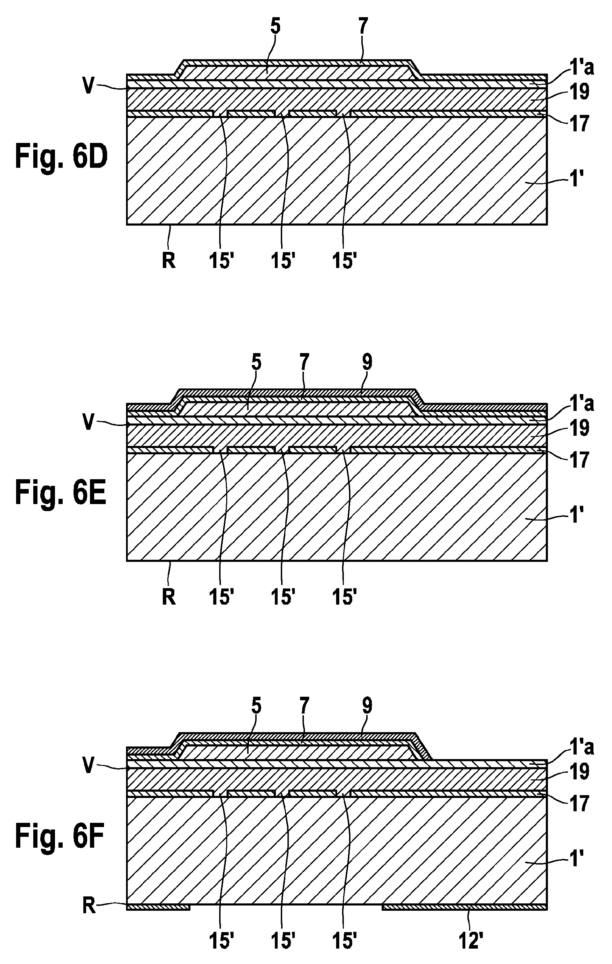

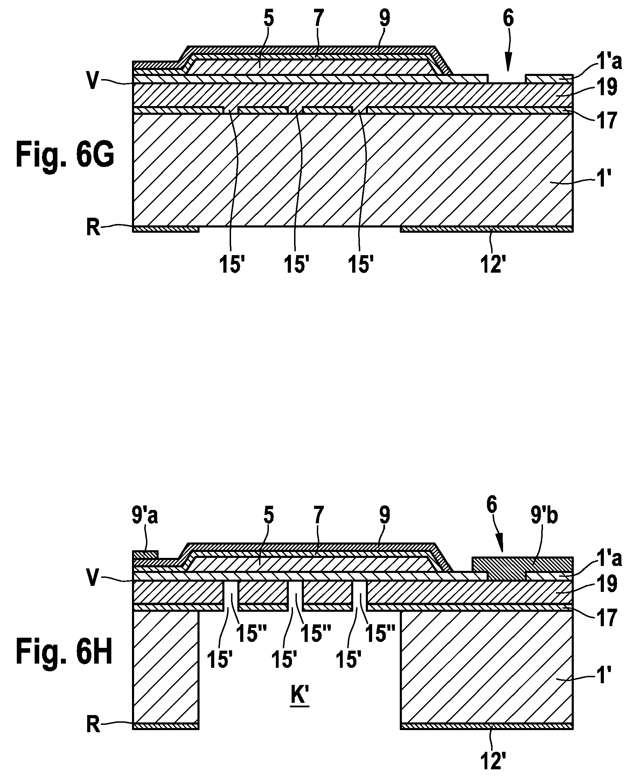

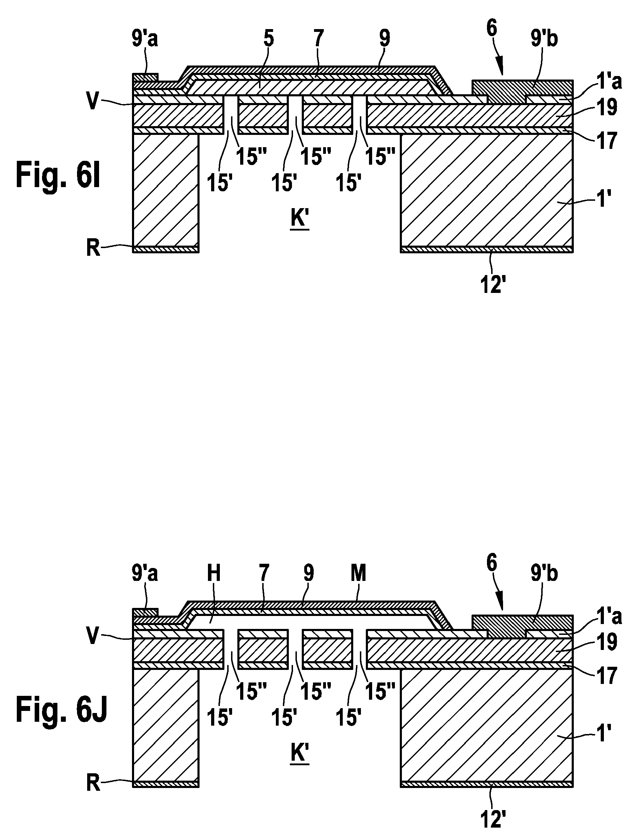

Hintergrund der Erfmdungsvarianten in Fig. 5 bzw. Fig. 6 ist die Notwendigkeit, Diffusionsbarrieren für Germanium zwischen der SiGe-Opferschicht und der unteren Silizium- oder Epi-Polysiliziumschicht anzulegen in denjenigen Fällen, wo nach der SiGe-Abscheidung auf dem Wafer noch Hochtemperaturschritte vorgesehen sind. Hochtemperaturschritte können z.B. eingesetzt werden, um Oxidschichten auf Silizium oder SiGe aufzuwachsen. Diese thermische Oxidation geht bei Temperaturen >900°C, bevorzugt bei Temperaturen >1000°C, z.B. bei 1100°C vonstatten. Ein weiterer Fall einer Hochtemperaturbehandlung liegt vor, wenn das als mikromechanisches Membranmaterial verwendete LPCVD-Polysilizium in seinen mechanischen Eigenschaften verändert, insbesondere verbessert werden soll, d.h. z.B. definierte Zugspannung und niedrige Spannungsgradienten eingestellt, das Material stabil gemacht oder einfach nur eingebrachte Dotierstoffe aktiviert werden sollen, um das Polysilizium elektrisch sehr gut leitfähig zu machen. Beispielsweise kann durch eine Temperung bei 1100°C über eine Zeitdauer von 10 Minuten bis 1 Stunde in in einem LPCVD-Reaktor zuvor abgeschiedenem Polysilizium ein definierter, niedriger Zugstress von z.B. 50 MPa eingestellt werden und gleichzeitig Dotierstoffe aktiviert werden, was beides für die Funktion als Membranmaterial sehr vorteilhaft und daher anzustreben ist. Bei solch hohen Temperaturen wird Germanium mobil und weist eine messbare Diffusionsgeschwindigkeit in Silizium auf, d.h. Ge-Atome können in Silizium während der angegebenen Zeiträume Wegstrecken von einigen µm zurücklegen. Während einer dergestaltigen Hochtemperaturbehandlung muss in allen Fällen sichergestellt werden, dass Ge nicht in zu hoher Konzentration (%-Bereich) in benachbartes oder angrenzendes Silizium eindiffundiert, da durch diese Interdiffusion Silizium in SiGe verwandelt würde und infolgedessen bei der nachfolgenden Opferschichtätzung die Selektivität der Ätzreaktion verloren gehen würde. Die Diffusionsgeschwindigkeit von Ge ist besonders gross in polykristallinen Siliziumschichten, d.h. wenn die Ge-haltige Schicht an Polysilizium oder EpiPolysilizium angrenzt, da die polykristallinen Materialien Korngrenzen besitzen, die eine besonders schnelle Ausbreitung des Ge entlang der Korngrenzen möglich machen. Während die Ge-Diffusion in angrenzendes einkristallines Silizium auch ohne Schutzmassnahmen bei den angegebenen Prozesszeiten nahezu vernachlässigbar bleibt, wäre die Ge-Diffusion entlang der Korngrenzen von polykristallinem Silizium um ein Vielfaches beschleunigt und nicht mehr zu vernachlässigen. In den Fällen, wo eine untere EpiPoly-Siliziumschicht 19 vorgesehen ist und eine Hochtemperaturbehandlung erfolgen soll, muss also unter allen Umständen eine Diffusionsbarriere zur darüber abgeschiedenen SiGe-Opferschicht vorgesehen werden, um störende Ausdiffusion von Ge und Korngrenzendiffusion im polykristallinen Si-Material zuverlässig zu unterdrücken. Dies besorgt die weitere dielektrische Schicht 1a in den Varianten der Fig. 5 und 6, die z.B. als dünne Siliziumoxidschicht ausgeführt werden kann mit einer Dicke von beispielsweise < 500 nm, bevorzugt < 100 nm. Siliziumoxidschichten von nur wenigen 10 nm Dicke genügen bereits, um Ge-Diffusion auch bei hohen Temperaturen zuverlässig zu unterbinden.

Gemäß Fig. 5A wird zu vorstehend beschriebenen Zweck auf dem Siliziumwafersubstrat 1 zunächst eine Siliziumoxidschicht 1a vorgesehen, und zwar entweder durch thermische Oxidation oder durch ein entsprechendes Abscheideverfahren. Diese dünne Oxidschicht dient u.a. als Diffusionsbarriere gegenüber der nachfolgend aufgebrachten SiGe-Opferschicht, namentlich als Ge-Diffusionsstopp bei hohen Temperaturen. Im Anschluss daran wird die Opferschicht 5 abgeschieden und strukturiert, wie bereits im Zusammenhang mit den vorhergehenden Ausführungsformen ausführlich erläutert.

Weiter mit Bezug auf Fig. 5B erfolgt die Abscheidung der dielektrischen Schicht 7, hier speziell in Form von SiO₂ und/oder Si₃N₄, wodurch insbesondere die Einstellung geeigneter Spannungszustände im Schichtsystem möglich wird. Beispielsweise weist eine sehr dünne (100 nm) LPCVD-Nitridschicht (Si₃N₄) eine ausreichend hohe intrinsische Zugspannung auf, um die gesamte spätere Membran unter Zug zu setzen, was für die Funktion der dadurch ebenen Membran besonders vorteilhaft ist. Auch eine Kombination aus einem unteren sehr dünnen Oxid und darüber befindlichen Nitrid erfüllt diese Funktion der Erzeugung einer ausreichend hohen Zugspannung, wobei das untere Oxid das Nitrid später bei der Opferschichtätzung vorteilhaft vor einem Ätzangriff durch Reaktionsprodukte der ClF₃-Ätzung schützt. Dieses untere Oxid oder die Oxidschicht alleine kann auch thermisch durch Oxidation auf der SiGe-Opferschicht aufgewachsen werden, da während der thermischen SiGe-Oxidation und damit Hochtemperaturbehandlung eine Ausdiffusion von Ge-Atomen in das darunterliegende Siliziumsubstrat vermöge der Diffusionsbarriere 1a ja wirksam unterbunden wird. Weiter mit Bezug auf Fig. 5C wird über der dielektrischen Schicht 7 die elektrisch leitende Schicht 9 aus Polysilizium abgeschieden und, wie sich aus Fig. 5D ergibt, in einem Ätzschritt, z.B. einem Plasmaätzschritt, gleichzeitig mit der dielektrischen Schicht 7 strukturiert. Auch hier besteht die vorteilhafte Option, durch eine Hochtemperaturbehandlung der Polysiliziumschicht 9 nach deren Abscheidung im LPCVD-Reaktor bei niedriger Temperatur (T~600°C) diese nachträglich in ihren mechanischen Eigenschaften zu verbessern und gleichzeitig die gewünschte elektrische Leitfähigkeit einzustellen.

Weiter mit Bezug auf Fig. 5E und 5F wird zunächst ein Fenster 6 in der Siliziumoxidschicht 1a geöffnet, um das Siliziumwafersubstrat 1 freizulegen, und danach eine weitere elektrisch leitfähige Schicht 9'a,b abgeschieden und strukturiert. Die elektrisch leitfähige Schicht wird dabei gänzlich vom Membranbereich entfernt und nur noch in der Peripherie des Membranbereichs belassen, und zwar auf der in der Fig. 5F linken Seite im Bereich 9'a zum Anschluss der leitfähigen Polysiliziumschicht 9 und auf der in Fig. 5F rechten Seite im Bereich 9'b zum Anschluss des Siliziumwafersubstrats.

Weiterhin ist in Fig. 5F gezeigt, dass auf der Waferrückseite R die Maskierschicht 12' aus dickem Photolack aufgebracht wird und mit deren Hilfe der Trenchprozess mit dem bereits erwähnten Plasmaätzverfahren durchgeführt wird, wobei hier die Oxidschicht 1a als Ätzstopp wirkt, wodurch eine gewisse Prozesssicherheit gegenüber Überätzen ermöglicht wird. Alternativ kann an dieser Stelle auch analog zu den Prozessschritten der Figuren 1D-1F verfahren werden, d.h. mit einem zweistufigen Tiefenätzprozess und einer zweistufigen Ätzmaskierung auf der Waferrückseite, um eine Kaverne und Perforationsöffnungen für die Funktion als Mikrofon herstellen zu können.

Wie in Fig. 5G dargestellt, wird anschließend die Oxidschicht in den Perforationslöchern 15"', welche durch das Trenchätzen entstanden sind, geöffnet, um die Opferschicht 5 freizulegen. Nach dem Öffnen der Oxidschicht 1a wird die Opferschicht 5 durch das bereits erwähnte ClF₃-Opferschichtätzen selektiv entfernt. Dabei wird die Wafervorderseite V vorzugsweise durch eine zuvor aufgebrachte Lackschicht, z.B. Photolack oder Polyimid oder auflaminierte Folie, vor Beschädigungen während der Phase-down-Prozessierung und eventuell auch während späteren Sägeprozessschritten und Reinigung geschützt. Die dielektrische Schicht 7 bleibt bei dieser Ausführungsform im Membranbereich erhalten und bildet einen Bestandteil der doppellagigen Membran M oberhalb des Hohlraums H, obwohl sie wie bei der vorhergehenden Ausführungsform ebenfalls entfernt werden könnte.

Als weitere Variante für diese und andere Ausführungsformen sei erwähnt, dass abweichend von der Abscheidung der dielektrischen Schicht 7 auf der Opferschicht 5 auch das Silizium-Germanium der Opferschicht 5 thermisch oxidiert werden kann. Das dabei entstehende Oxid dient dann als Dielektrikum. Ein Vorteil dieser Variante ist es, dass dann die Abscheidung und Strukturierung der dielektrischen Schicht 7 entfallen kann. Das derart gebildete thermische Oxid wächst vorteilhaft fast nur auf den jeweiligen strukturierten SiGe-Bereichen auf, was einen selbstjustierten Prozess darstellt, da SiGe deutlich schneller thermisch oxidiert als Si. Im Anschluss an diese thermische Oxidation würde dann die ganzflächige Abscheidung der Polysiliziumschicht 9 stattfinden, wobei die thermisch aufgewachsene Oxidschicht wiederum als Diffusionsbarriere zwischen dem Polysilizium-Germanium und dem Polysilizium bei einer später nachfolgenden Hochtemperaturbehandlung dient. Dabei ist es besonders vorteilhaft, dass bis zu einem Germaniumanteil von weniger als 50% in der Silizium-Germanium-Schicht das darauf thermisch aufgewachsene Oxid kein Germanium enthält, weil Germaniumoxid durch den Siliziumüberschuss der SiGe/SiO₂-Grenzschicht durch Si ständig reduziert wird, wobei reines SiO₂ gebildet wird. Man erhält somit unter diesen Bedingungen ein Siliziumoxid, das weitestgehend frei von Germaniumoxiden bleibt, was Vorteile hinsichtlich der Unterdrückung der Germaniumdiffusion mit sich bringt.

Fig. 6A-J zeigen schematische Querschnittsansichten der wesentlichen Herstellungsschritte eines mikromechanischen Bauelements in Form eines Mikrofons oder Drucksensors gemäß einer sechsten Ausfühmngsform der vorliegenden Erfindung. Auch ist vor dem Hintergrund einer Hochtemperaturbehandlung eine Diffusionsbarriere 1'a zwischen SiGe-Opferschicht 5 und unterer Epi-Polysiliziumschicht 19 vorgesehen.

Die in Fig. 6A bis 6J gezeigte Ausführungsform ist eine analoge Abwandlung der zweiten Ausführungsform wie die vorhergehende fünfte Ausführungsform zur ersten Ausführungsform. Die Prozessschritte gemäß Fig. 6A und 6B entsprechen den Prozessschritten gemäß Fig. 2A und 2B. Im Prozessschritt gemäß Fig. 6C erfolgt dann das Abscheiden bzw. Aufoxidieren der Oxidschicht 1'a auf der epitaktischen Polysiliziumschicht 19. Diese Oxidschicht dient vorwiegend als Diffusionsbarriere, um das Eindiffundieren und die rasche Ausbreitung von Ge aus der SiGe-Opferschicht ins und im EpiPoly-Silizium 19 während darauffolgender Hochtemperaturprozessschritte zu unterdrücken. Da Ge bei hohen Temperaturen eine schnelle Korngrenzendiffusion in Polysilizium zeigt, ist diese Maßnahme wie vorstehend beschrieben notwendig. Darauf erfolgt die Abscheidung und Strukturierung der Opferschicht 5 und danach die Abscheidung der dielektrischen Schicht 7 gemäß Fig. 6D und der darüber befindlichen elektrisch leitenden Schicht 9 aus Polysilizium gemäß Fig. 6E.

In Fig. 6F ist die gleichzeitige Strukturierung der dielektrischen Schicht 7 und der leitfähigen Schicht 9 gezeigt. Weiterhin wird die Maskierschicht 12' auf der Waferrückseite R aus Photolack gebildet.

Gemäß Fig. 6G erfolgt die Bildung des Fensters 6 in der Siliziumoxidschicht 1a zur Freilegung und darauffolgenden elektrischen Kontaktierung der epitaktischen Polysiliziumschicht 19.

Weiter mit Bezug auf Fig. 6H erfolgt dann der Trenchätzprozess, welcher die Kaverne K' unterhalb des Membranbereichs ausbildet und dann durch die Löcher 15' der dielektrischen Schicht 17 weiter verläuft in die Perforationsöffnungen 15" der epitaktischen Polysiliziumschicht 19 und schließlich an der Siliziumoxidschicht 1'a stoppt. Wie bei der vorhergehenden Ausführungsform wird dann gemäß Fig. 6I die freigelegte Siliziumoxidschicht 1'a von der Waferrückseite R her geöffnet und danach die Opferschicht 5 durch den bereits erwähnten ClF₃-Opferschichtätzprozess entfernt zur Freilegung von Membran und Hohlraum H. Auch bei dieser Ausführungsform bleibt die dielektrische Schicht 7 im Membranbereich erhalten.

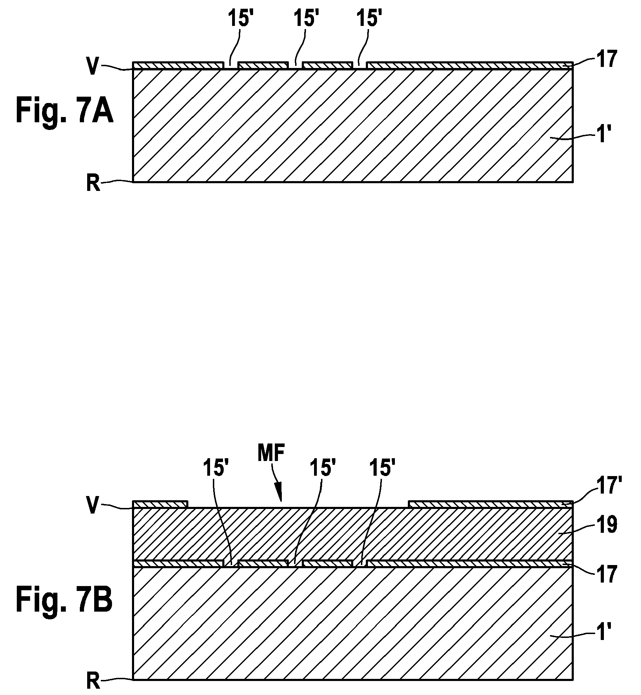

Fig. 7A-L zeigen schematische Querschnittsansichten der wesentlichen Herstellungsschritte eines mikromechanischen Bauelements in Form eines kapazitiven Mikrofons oder Drucksensors gemäß einer nicht beanspruchten siebenten Ausführungsform der vorliegenden Erfindung.

Mit Bezug auf Figur 7 A wird auf einem Siliziumwafersubstrat 1' eine dielektrische Schicht 17 beispielsweise aus Siliziumoxid auf der Wafervorderseite V abgeschieden bzw. thermisch aufoxidiert. In der dielektrischen Schicht 17 werden Maskenöffnungen 15' entsprechend späteren Perforationslöchern in der späteren Gegenplatte als Fenster lithografisch definiert und geöffnet.

Weiter mit Bezug auf Figur 7 B wird eine Polysiliziumschicht 19 auf der Wafervorderseite V ganzflächig abgeschieden. Bis zu diesem Verfahrensstadium entspricht die siebte Ausführungsform somit der oben erläuterten zweiten Ausführungsform. Im Anschluss an die Abscheidung der Polysiliziumschicht 19 wird dann eine Maskenschicht 17' beispielsweise ebenfalls aus Siliziumoxid auf der Vorderseite V abgeschieden und derart strukturiert, dass sie ein Fenster MF im Bereich der späteren Membran aufweist. Im Übrigen dient diese Maskenschicht 17' aus Siliziumoxid später auch als Isolationsschicht für das Endbauteil.

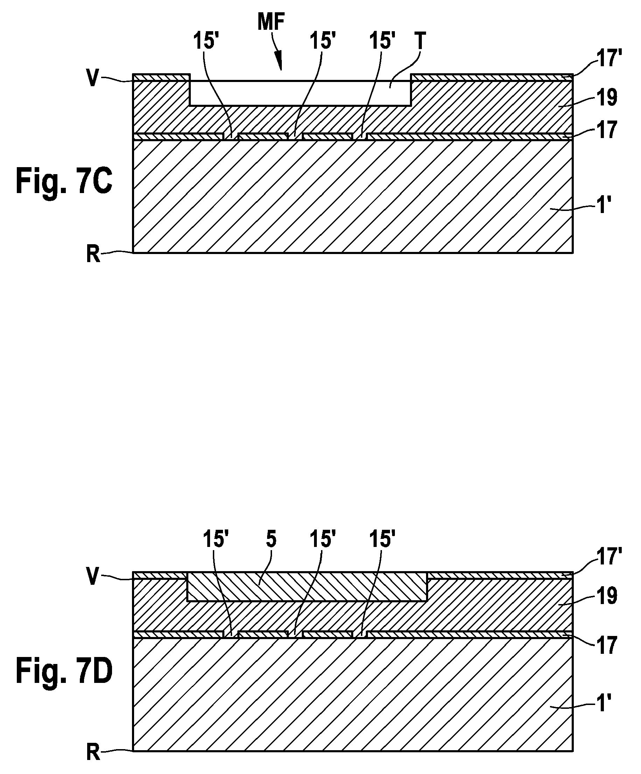

Mit Bezug auf Figur 7C erfolgt dann ein Trench-Ätzprozess zum Bilden einer grabenartigen Vertiefung T in der Polysiliziumschicht 19. Nach dem Trench-Ätzprozess wird in der Vertiefung T die Opferschicht 5 aus Silizium-Germanium bzw. Germanium selektiv gegenüber der umliegenden Maskenschicht 17' abgeschieden, was zum Prozesszustand gemäß Figur 7 D führt, bei welchem die grabenartige Vertiefung T in der Polysiliziumschicht 19 durch SiGe bzw. Ge wieder aufgefüllt wurde.

Alternativ kann nach dem Öffnen der Fenster MF im Bereich der späteren Membran mit Hilfe der Maskenschicht 17' aus Siliziumoxid als Implantationsmaske in den Fenstern MF durch Ionenimplantation mit Germanium inselartige Ge-dotierte Bereiche erzeugt werden.

Weiter mit Bezug auf 7 E wird eine weitere dünne Oxidschicht 7' auf der Vorderseite aufgebracht (PECVD bzw. LPCVD) bzw. thermisch aufgewachsen.

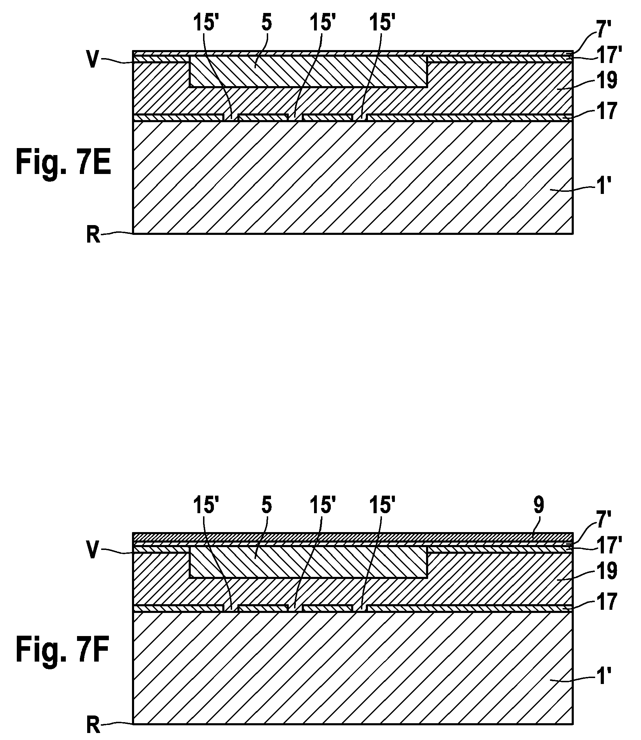

Gemäß Figur 7 F wird analog zur Figur 2E bzw. 1C die elektrisch leitende Schicht 9 aus Polysilizium über der gesamten Struktur ganzflächig abgeschieden. Zur Einstellung der mechanischen Eigenschaften der Polysiliziumschicht 9 kann diese nachfolgend getempert werden.

Die möglichen Materialien und Varianten für die Schichten 7' und 9 sind genau dieselben wie bei der obigen ersten bzw. zweiten Ausführungsform. Die Schicht 7' entspricht dabei funktionell der Schicht 7 bei der ersten bzw. zweiten Ausführungsform.

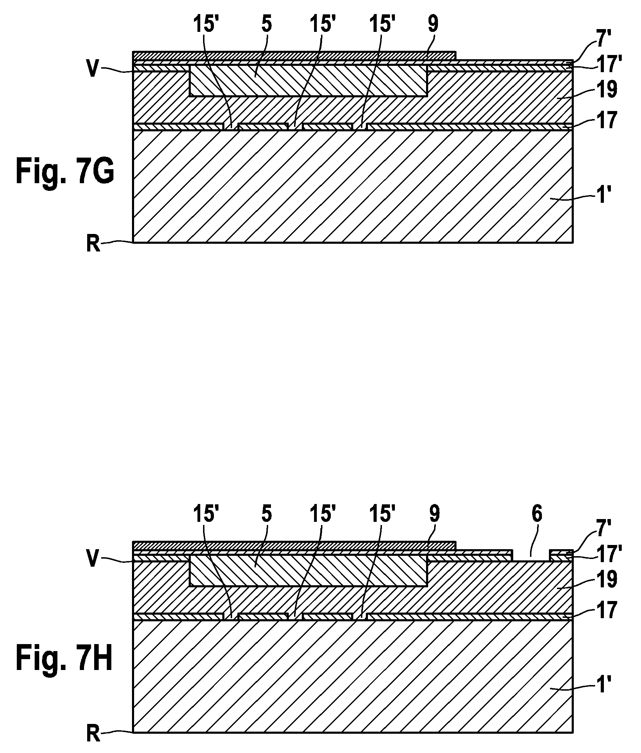

Im folgenden Prozessschritt, der in Figur 7 G illustriert ist, werden zunächst die leitfähige Schicht 9 aus Polysilizium und danach die freigelegten Oxidschichten 7', 17' strukturiert, um das Fenster 6 zu bilden, welches den Zugang zur Gegenelektrode in Form der Polysiliziumschicht 19 vorsieht, was schließlich zum Prozesszustand gemäß Figur 7 H führt.

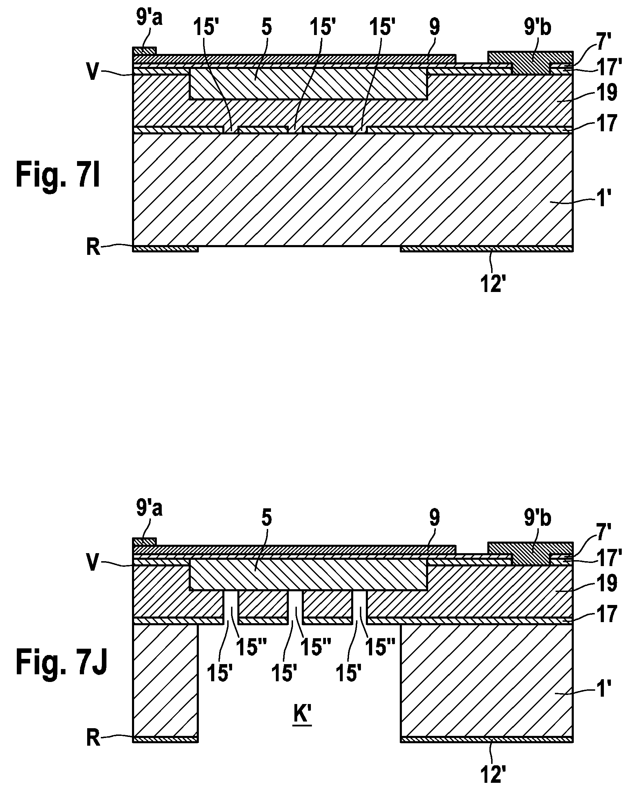

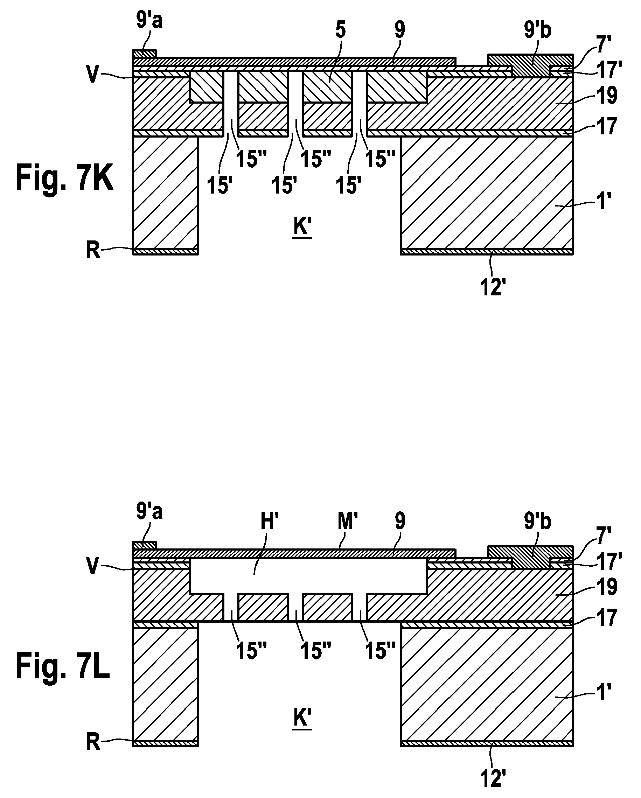

Weiter mit Bezug auf Figur 7I wird eine leitfähige Schicht abgeschieden, welche im Bereich 9'a die leitfähige Schicht 9 außerhalb des Membranbereichs und im Bereich 9'b das Siliziumwafersubstrat 1 durch das Fenster 6 kontaktiert. Im Prozessschritt gemäß Figur 7 I wird ebenfalls auf der Waferrückseite R eine Maskierschicht 12' aufgebracht, bei der es sich vorzugsweise um eine dicke Lackmaske handelt, die derart strukturiert wird, dass die Kaverne K sich unter der späteren Membran befindet. Alternativen hinsichtlich der Maskierschicht 12' sind bereits oben im Zusammenhang mit der zweiten Ausführungsform erläutert.

Wie in Figur 7 J dargestellt, erfolgt dann der einstufige Tiefenätzprozess zum Trenchen, wobei die Kaverne K' flächig von der Waferrückseite R zur Wafervorderseite V hingetrieben wird. Der Tiefenätzprozess stoppt flächig auf der strukturierten dielektrischen Schicht 17 zwischen dem Siliziumwafersubstrat 1' und der epitaktischen Polysiliziumschicht 19. Ausgenommen in den Maskenöffnungen 15', wo der Tiefenätzprozess anschließend noch in der epitaktischen Polysiliziumschicht 19 bis zur Wafervorderseite V hin weiter voranschreitet und, falls gewünscht auch noch durch die Opferschicht 5 zur Ausbildung von sich an die Maskenöffnungen 15' anschließenden Perforationsöffnungen 15". Der Ätzprozess stoppt nach dem Durchätzen der Opferschicht 5 auf der dielektrischen Schicht 7', welcher einen Teil der späteren Membran bildet. So wird der in Figur 7 K gezeigte Prozesszustand erreicht.

In einem abschließenden Prozessschritt, der auf Figur 7 L gezeigt ist, wird dann wieder mittels der bereits beschriebenen isotropen Ätzung mit ClF₃ von der Waferrückseite R her die Opferschicht 5 hochselektiv entfernt, um die Membran M' und den Hohlraum H' zu bilden. Die derart hergestellte Membran M' weist keinen Stufenwinkel mehr auf, was sich positiv auf den Spannungszustand der Membran auswirkt.

Im Unterschied zu der oben erläuterten zweiten Ausführungsform wird bei der vorliegenden Ausführungsform das in der Kaverne K' und im Hohlraum H' verbleibende Oxid der Oxidschichten 17 bzw. 7', 17' mittels eines zusätzlichen Oxidätzschritt, beispielsweise HF-Dampf, entfernt. Dadurch kann der mechanische Spannungszustand beider Elektroden ebenfalls vorteilhaft beeinflusst werden.

### Bezugszeichenliste

- 1, 1': Siliziumwafersubstrat
- 5, 40: Opferschicht
- V: Wafervorderseite
- R: Waferrückseite
- 7, 7': dielektrische Schicht
- 6: Fenster
- 9, 9a, 9b: leitfähige Schicht
- 9',9'a,9'b: leitfähige Schicht
- 11: Maskierschicht
- 12, 12': Maskierschicht
- 15': Maskenöffnung von dielektrischer Schicht
- 15, 15", 15"': Perforationslöcher
- M,M': Membran
- 17: dielektrische Schicht
- 17': dielektrische Maskenschicht
- MF: Fenster
- 19, 20, 30: Polysiliziumschicht
- 1a, 1'a: Oxidschicht, (Diffusionsbarriere für Ge)
- 5: SiGe-Opferschicht
- K, K': Kaverne
- 25, 25', 45: Oxidschicht
- H,H': Hohlraum

## Patentansprüche

1. Herstellungsverfahren für ein mikromechanisches Bauelement mit den Schritten:
- Bereitstellen eines leitfähigen Substrats (1; 1', 17, 19); und
- Vorsehen eines inselartigen Bereichs einer Opferschicht (5) über oder in einer Vorderseite (V) des Substrats (1; 1', 17, 19);
wobei vorgesehen ist, dass die Opferschicht (5) aus Ge oder SiGe, vorzugsweise aus Si₁₋ₓGeₓ mit x=0,1-0,8, besonders bevorzugt mit x=0,2-0,5 besteht; und
- Vorsehen mindestens einer leitfähigen Schicht (9; 9a) über der Opferschicht (5), wobei die leitfähige Schicht (9; 9a) gegenüber dem Substrat (1; 1', 17, 19) elektrisch isoliert ist; und
- Vorsehen einer dielektrischen Schicht (1a; 1'a) in Form einer Siliziumoxidschicht auf der Vorderseite des Substrats (1; 1', 17, 19) zwischen dem Substrat (1; 1', 17, 19) und der Opferschicht (5) ; und
- Vorsehen einer Mehrzahl von durch das Substrat (1; 1', 17, 19) verlaufenden Perforationsöffnungen- bzw. Perforationslöchern (15"'), welche sich bis mindestens zum inselartigen Bereich der Opferschicht (5) erstrecken; wobei die Perforationslöcher durch einen Trenchätzprozess bis zur dielektrischen Schicht (1a; 1'a) und die Perforationsöffnungen durch eine anschließende Öffnung der dritten elektrischen Schicht in den Perforationslöchern (15"") gebildet werden, wobei die dritte dielektrische Schicht (1a; 1'a, 17') einen Ätzstopp für den Trenchätzprozess darstellt, und wobei vorgesehen ist, dass die dielektrische Schicht (1a; 1'a) eine Diffusionsbarriere für Ge darstellt; und
- Entfernen der Opferschicht (5) durch einen ersten Ätzprozess von einer Rückseite (R) des Substrats (1; 1', 17, 19) her durch die Perforationsöffnungen bzw. Perforationslöchern (15"') zum Schaffen eines Hohlraums (H; H'), der eine elastisch auslenkbare Membran (M; M') mit mindestens der leitfähigen Schicht (9; 9a) freilegt, die über einer Vorderseite (V) des Substrats (1; 1', 17,19) vorgesehen ist.

2. Herstellungsverfahren nach Anspruch 1, **dadurch gekennzeichnet, dass** der inselartige Bereich der Opferschicht (5) über der Vorderseite (V) des Substrats (1; 1', 17, 19) vorgesehen wird, so dass die Membran (M) nach dem Entfernen der Opferschicht (5) gewölbt über einer Vorderseite (V) des Substrats (1; 1', 17, 19) vorgesehen ist.

3. Herstellungsverfahren nach Anspruch 1, **dadurch gekennzeichnet, dass** der inselartige Bereich der Opferschicht (5) in der Vorderseite (V) des Substrats (1; 1', 17, 19) vorgesehen wird, so dass die Membran (M') nach dem Entfernen der Opferschicht (5) eben über einer Vorderseite (V) des Substrats (1; 1', 17, 19) vorgesehen ist.

4. Herstellungsverfahren nach Anspruch 3, **dadurch gekennzeichnet, dass** der inselartige Bereich der Opferschicht (5) in der Vorderseite (V) des Substrats (1; 1', 17, 19) durch folgende Schritte vorgesehen wird:
Vorsehen einer dielektrischen Maskierschicht (17') auf der Vorderseite (V) des Substrats (1; 1', 17, 19) mit einer Maskenöffnung (MF) entsprechend dem inselartigen Bereich;
Ätzen eines Grabens (T) in der Vorderseite (V) des Substrats (1; 1', 17, 19) mittels der Maskierschicht (17'); und
selektives Abscheiden des inselartigen Bereichs der Opferschicht (5) in dem Graben (T) gegenüber der Maskierschicht (17').

5. Herstellungsverfahren nach Anspruch 3, **dadurch gekennzeichnet, dass** der inselartige Bereich der Opferschicht (5) in der Vorderseite (V) des Substrats (1; 1', 17, 19) durch folgende Schritte vorgesehen wird:
Vorsehen einer dielektrischen Maskierschicht (17') auf der Vorderseite (V) des Substrats (1; 1', 17, 19) mit einer Maskenöffnung (MF) entsprechend dem inselartigen Bereich;
Implantieren von Germanium in den Maskenöffnungen (MF) zur Bildung der inselartigen Ge-dotierten Bereiche mittels Ionenimplantation.

6. Herstellungsverfahren nach einem der Ansprüche 1 bis 5, **dadurch gekennzeichnet, dass** unterhalb der Membran (M;M') eine Kaverne (K; K') vorgesehen wird, wobei die Perforationsöffnungen (15; 15") in die Kaverne (K; K') führen.

7. Herstellungsverfahren nach einem der Ansprüche 1 bis 6, **dadurch gekennzeichnet, dass** das Substrat (1; 1', 17, 19) ein Wafersubstrat (1'), eine darauf befindliche zweite dielektrische Schicht (17) und eine darauf befindliche Schicht (19) aus Substratmaterial aufweist und die Perforationsöffnungen (15") beim ersten Ätzprozess durch Maskenöffnungen (15') definiert werden, die in der dielektrischen Schicht (17) vorgesehen werden, wobei die zweite dielektrische Schicht (17) das Wafersubstrat (1') und die darauf befindliche Schicht (19) aus Substratmaterial elektrisch voneinander isoliert.

8. Herstellungsverfahren nach einem der Ansprüche 1 bis 7, **dadurch gekennzeichnet, dass** mindestens eine dielektrische Schicht (7; 7') über der Opferschicht (5) unter der leitfähigen Schicht (9; 9a) vorgesehen wird, wobei die leitfähige Schicht (9; 9a) gegenüber dem Substrat (1; 1', 17, 19) durch die dielektische Schicht (7; 7') elektrisch isoliert ist.

9. Herstellungsverfahren nach Anspruch 8, **dadurch gekennzeichnet, dass** die mindestens eine dielektische Schicht (7; 7') in einem zweiten Ätzprozess von der Rückseite (R) des Substrats (1; 1', 17, 19) her durch die Perforationsöffnungen (15; 15"; 15"') entfernt wird.

10. Herstellungsverfahren nach einem der Ansprüche 1 bis 9, **dadurch gekennzeichnet, dass** die Opferschicht (5) aus Ge oder SiGe besteht und mit einem Ätzgas aus der Gruppe ClF₃, ClF₅, BrF₃, XeF₂, IF₃ oder IF ₅selektiv geätzt wird.

11. Herstellungsverfahren nach einem der Ansprüche 1 bis 10, **dadurch gekennzeichnet, dass** die Opferschicht (5) aus SiGe mit einem Ge-Gehalt < 50 % besteht und mit einem Ätzgas von ClF₃ selektiv geätzt wird.

12. Herstellungsverfahren nach Anspruch 11, **dadurch gekennzeichnet, dass** die dielektrische Schicht (7; 7') unter der Membran (M) durch eine Ätzung mit dampfförmiger HF entfernt wird.

## Claims

1. Production method for a micromechanical component comprising the following steps:
- providing a conductive substrate (1; 1', 17, 19); and
- providing an island-like region of a sacrificial layer (5) above or in a front side (V) of the substrate (1; 1', 17, 19); wherein provision is made for the sacrificial layer (5) to consist of Ge or SiGe, preferably of Si₁₋ₓGeₓ where x = 0.1-0.8, particularly preferably where x = 0.2-0.5; and
- providing at least one conductive layer (9; 9a) above the sacrificial layer (5), wherein the conductive layer (9; 9a) is electrically insulated from the substrate (1; 1', 17, 19); and
- providing a dielectric layer (1a; 1'a) in the form of a silicon oxide layer on the front side of the substrate (1; 1', 17, 19) between the substrate (1; 1', 17, 19) and the sacrificial layer (5); and
- providing a plurality of perforation openings and perforation holes (15"') which run through the substrate (1; 1', 17, 19) and which extend at least as far as the island-like region of the sacrificial layer (5); wherein the perforation holes are formed by a trench etching process as far as the dielectric layer (1a; 1'a) and the perforation openings are formed by a subsequent opening of the third electrical layer in the perforation holes (15"'), wherein the third dielectric layer (1a; 1'a, 17') constitutes an etch stop for the trench etching process, and wherein provision is made for the dielectric layer (1a; 1'a) to constitute a diffusion barrier for Ge; and
- removing the sacrificial layer (5) by a first etching process from a rear side (R) of the substrate (1; 1', 17, 19) through the perforation openings and perforation holes (15"') in order to create a hollow space (H; H') which exposes an elastically deflectable membrane (M; M') comprising at least the conductive layer (9; 9a) which is provided above a front side (V) of the substrate (1; 1', 17, 19).

2. Production method according to Claim 1, **characterized in that** the island-like region of the sacrificial layer (5) is provided above the front side (V) of the substrate (1; 1', 17, 19), such that the membrane (M), after the process of removing the sacrificial layer (5), is provided in a curved fashion above a front side (V) of the substrate (1; 1', 17, 19).

3. Production method according to Claim 1, **characterized in that** the island-like region of the sacrificial layer (5) is provided in the front side (V) of the substrate (1; 1', 17, 19), such that the membrane (M') after the process of removing the sacrificial layer (5), is provided in a planar fashion above a front side (V) of the substrate (1; 1', 17, 19).

4. Production method according to Claim 3, **characterized in that** the island-like region of the sacrificial layer (5) is provided in the front side (V) of the substrate (1; 1', 17, 19) by the following steps:
providing a dielectric masking layer (17') on the front side (V) of the substrate (1; 1', 17, 19) with a mask opening (MF) corresponding to the island-like region;
etching a trench (T) in the front side (V) of the substrate (1; 1', 17, 19) by means of the masking layer (17'); and
selectively depositing the island-like region of the sacrificial layer (5) in the trench (T) with respect to the masking layer (17').

5. Production method according to Claim 3, **characterized in that** the island-like region of the sacrificial layer (5) is provided in the front side (V) of the substrate (1; 1', 17, 19) by the following steps:
providing a dielectric masking layer (17') on the front side (V) of the substrate (1; 1', 17, 19) with a mask opening (MF) corresponding to the island-like region;
implanting germanium in the mask openings (MF) in order to form the island-like Ge-doped regions by means of ion implantation.

6. Production method according to any of Claims 1 to 5, **characterized in that** a cavity (K; K') is provided below the membrane (M; M') wherein the perforation openings (15; 15") lead into the cavity (K; K').

7. Production method according to any of Claims 1 to 6, **characterized in that** the substrate (1; 1', 17, 19) comprises a wafer substrate (1'), a second dielectric layer (17) situated thereon, and a layer (19) composed of substrate material situated thereon, and the perforation openings (15") are defined during the first etching process by mask openings (15') provided in the dielectric layer (17), wherein the second dielectric layer (17) electrically insulates the wafer substrate (1') and the layer (19) composed of substrate material situated thereon from one another.

8. Production method according to any of Claims 1 to 7, **characterized in that** at least one dielectric layer (7; 7') is provided above the sacrificial layer (5) below the conductive layer (9; 9a), wherein the conductive layer (9; 9a) is electrically insulated from the substrate (1; 1', 17, 19) by the dielectric layer (7; 7').

9. Production method according to Claim 8, **characterized in that** the at least one dielectric layer (7; 7') is removed in a second etching process from the rear side (R) of the substrate (1; 1', 17, 19) through the perforation openings (15; 15" ; 15"').

10. Production method according to any of Claims 1 to 9, **characterized in that** the sacrificial layer (5) consists of Ge or SiGe and is selectively etched using an etching gas from the group ClF₃, ClF₅, BrF₃, XeF₂, IF₃ or IF₅.

11. Production method according to any of Claims 1 to 10, **characterized in that** the sacrificial layer (5) consists of SiGe having a Ge content of < 50% and is selectively etched using an etching gas of ClF₃.

12. Production method according to Claim 11, **characterized in that** the dielectric layer (7; 7') is removed below the membrane (M) by an etch using vaporous HF.

## Revendications

1. Procédé de fabrication d'un composant micromécanique comprenant les étapes consistant à :
- fournir un substrat conducteur (1 ; 1', 17, 19) ; et
- disposer une zone en forme d'îlot d'une couche sacrificielle (5) sur ou dans une face avant (V) du substrat (1 ; 1', 17, 19) ;
dans lequel il est fait en sorte que la couche sacrificielle (5) soit constituée de Ge ou de SiGe, de préférence, de Si₁₋ₓGeₓ, avec x = 0,1-0,8, et de façon particulièrement préférable, avec x = 0,2-0,5 ; et
- disposer au moins une couche conductrice (9 ; 9a) sur la couche sacrificielle (5), dans lequel la couche conductrice (9 ; 9a) est électriquement isolée par rapport au substrat (1 ; 1', 17, 19) ; et
- disposer une couche diélectrique (1a ; 1'a) sous la forme d'une couche d'oxyde de silicium sur la face avant du substrat (1 ; 1', 17, 19) entre le substrat (1 ; 1', 17, 19) et la couche sacrificielle (5) ; et
- disposer une pluralité d'ouvertures de perforation ou d'orifices de perforation (15"') traversant le substrat (1 ; 1', 17, 19), qui s'étendent au moins jusqu'à la zone en forme d'îlot de la couche sacrificielle (5) ; dans lequel les orifices de perforation sont formés jusqu'à la couche diélectrique (la ; 1'a) et les ouvertures de perforation sont formées à travers une ouverture suivante de la troisième couche électrique dans les orifices de perforation (15"') par un processus de gravure de tranchées, dans lequel la troisième couche diélectrique (1a ; 1'a, 17') constitue un arrêt de gravure pour le processus de gravure de tranchées, et dans lequel la couche diélectrique (la ; 1'a) constitue une barrière de diffusion pour le Ge ; et
- enlever la couche sacrificielle (5) par un premier processus de gravure d'une face arrière (R) du substrat (1 ; 1', 17, 19) à travers les ouvertures de perforation ou les orifices de perforation (15"') pour créer un espace creux (H ; H') qui expose une membrane (M ; M') pouvant être écartée élastiquement comportant au moins la couche conductrice (9 ; 9a), laquelle membrane est disposée sur une face avant (V) du substrat (1 ; 1', 17, 19).

2. Procédé de fabrication selon la revendication 1, **caractérisé en ce que** la zone en forme d'îlot de la couche sacrificielle (5) est disposée sur la face avant (V) du substrat (1 ; 1', 17, 19) de manière à ce que la membrane (M), après que la couche sacrificielle (5) a été enlevée, soit disposée de manière bombée sur une face avant (V) du substrat (1 ; 1', 17, 19).

3. Procédé de fabrication selon la revendication 1, **caractérisé en ce que** la zone en forme d'îlot de la couche sacrificielle (5) est disposée dans la face avant (V) du substrat (1 ; 1', 17, 19) de manière à ce que la membrane(M'), après que la couche sacrificielle (5) a été enlevée, soit disposée de manière plane sur une face avant (V) du substrat (1 ; 1', 17, 19).

4. Procédé de fabrication selon la revendication 3, **caractérisé en ce que** la zone en forme d'îlot de la couche sacrificielle (5) est disposée dans la face avant (V) du substrat (1 ; 1', 17, 19) par les étapes consistant à :
doter une couche de masquage diélectrique (17'), sur la face avant (V) du substrat (1 ; 1', 17, 19), d'une ouverture de masquage (MF) correspondant à la zone en forme d'îlot ;
graver une tranchée (T) dans la face avant (V) du substrat (1 ; 1', 17, 19) au moyen de la couche de masquage (17') ; et
déposer sélectivement la zone en forme d'îlot de la couche sacrificielle (5) dans la tranchée (T) par rapport à la couche de masquage (17').

5. Procédé de fabrication selon la revendication 3, **caractérisé en ce que** la zone en forme d' îlot de la couche sacrificielle (5) est disposée dans la face avant (V) du substrat (1 ; 1', 17, 19) par les étapes consistant à :
doter une couche de masquage diélectrique (17'), sur la face avant (V) du substrat (1 ; 1', 17, 19), d'une ouverture de masquage (MF) correspondant à la zone en forme d'îlot ;
implanter du germanium dans les ouvertures de masquage (MF) pour former des zones dopées Ge en forme d'îlots par implantation ionique.

6. Procédé de fabrication selon l'une quelconque des revendications 1 à 5, **caractérisé en ce qu'**il est prévu une cavité (K ; K') en-dessous de la membrane (M ; M'), dans lequel les ouvertures de perforation (15 ; 15") conduisent à la cavité (K ; K').

7. Procédé de fabrication selon l'une quelconque des revendications 1 à 6, **caractérisé en ce que** le substrat (1 ; 1', 17, 19) comprend un substrat de plaquette (1'), une deuxième couche (17) disposée sur ce dernier, et une couche (19) disposée sur cette dernière et constituée de matériau de substrat et **en ce que** les ouvertures de perforation (15") sont définies lors du premier processus de gravure à travers des ouvertures de masquage (15') qui sont disposées dans la couche diélectrique (17), dans lequel la deuxième couche diélectrique (17) isole électriquement l'un de l'autre le substrat de plaquette (1') et la couche (19) disposée sur celui-ci et constituée de matériau de substrat.

8. Procédé de fabrication selon l'une quelconque des revendications 1 à 7, **caractérisé en ce qu'**au moins une couche diélectrique (7 ; 7') est disposée sur la couche sacrificielle (5), en-dessous de la couche conductrice (9 ; 9a), dans lequel la couche conductrice (9 ; 9a) est électriquement isolée du substrat (1 ; 1', 17, 19) par la couche diélectrique (7 ; 7').

9. Procédé de fabrication selon la revendication 8, **caractérisé en ce que** l'au moins une couche diélectrique (7 ; 7') est enlevée de la face arrière (R) du substrat (1 ; 1', 17, 19) à travers les ouvertures de perforation (15 ; 15" ; 15"') par un deuxième processus de gravure.

10. Procédé de fabrication selon l'une quelconque des revendications 1 à 9, **caractérisé en ce que** la couche sacrificielle (5) est constituée de Ge ou de SiGe et est sélectivement gravée par un gaz de gravure choisi dans le groupe constitué du ClF₃, du ClF₅, du BrF₃, du XeF₂, de l'IF₃ ou de l'IF₅.

11. Procédé de fabrication selon l'une quelconque des revendications 1 à 10, **caractérisé en ce que** la couche sacrificielle (5) est constituée de SiGe avec une teneur en Ge < 50 % et est sélectivement gravée par un gaz de gravure de CIF₃.

12. Procédé de fabrication selon la revendications 11, **caractérisé en ce que** la couche diélectrique (7 ; 7') se trouvant en-dessous de la membrane (M) est enlevée par gravure par du HF sous forme vapeur.
